(19) Europäisches Patentamt
European Patent Office
Office européen des brevets

(11) EP 4 365 328 A1

(12) EUROPEAN PATENT APPLICATION

(43) Date of publication:
08.05.2024 Bulletin 2024/19

(21) Application number: 23201872.1

(22) Date of filing: 05.10.2023

(51) International Patent Classification (IPC):
C23C 16/34 (2006.01)    C23C 16/44 (2006.01)
C23C 16/455 (2006.01)    H01L 21/02 (2006.01)

(52) Cooperative Patent Classification (CPC):
C23C 16/45578; C23C 16/345; C23C 16/4412;
C23C 16/45546; H01L 21/0217; H01L 21/02211;
H01L 21/0228; H01L 21/0262

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.10.2022   JP 2022175067

(71) Applicant: Kokusai Electric Corp.
Tokyo 1010045 (JP)

(72) Inventors:
• URUSHIHARA, Mika
  Toyama, 9392393 (JP)
• HIRANO, Atsushi
  Toyama, 9392393 (JP)
• SASAKI, Takafumi
  Toyama, 9392393 (JP)

(74) Representative: Bardehle Pagenberg
Partnerschaft mbB
Patentanwälte Rechtsanwälte
Prinzregentenplatz 7
81675 München (DE)

(54) SUBSTRATE PROCESSING APPARATUS, METHOD OF MANUFACTURING SEMICONDUCTOR DEVICE, AND USE OF SUBSTRATE PROCESSING APPARATUS

(57) There is provided a technique that includes (a) a process chamber (201) configured to accommodate a plurality of substrates (200) arranged vertically, provided with a product region (P) and a dummy region (TSD, BSD) and including a main exhauster (236) on a lateral side thereof, (b) a first injector (340a, 340b, 341a, 341b) extending vertically within the process chamber (201) on an opposite side from the main exhauster(236), and configured to supply a first precursor toward the substrates (200) accommodated in the product region (P) and the dummy region (TSD, BSD), (c) at least one selected from the group of a second injector (342c2) and a third injector (343a1, 343a2), wherein the second injector (342c2) supplies an assist gas for diluting the first precursor toward substrates (200) and the third injector (343a1, 343a2) supplies an inert gas toward the substrates (200) accommodated in the product region (P) and the substrates (200) accommodated in the dummy region (TSD, BSD); and (d) a fourth injector (343b) configured to supply an inert gas only to the dummy region (TSD, BSD).

FIG. 1

EP 4 365 328 A1

**Description**

CROSS-REFERENCE TO RELATED APPLICATION

This application is based upon and claims the benefit of priority from Japanese Patent Application No. 2022-175067, filed on October 31, 2022, the entire contents of which are incorporated herein by reference.

TECHNICAL FIELD

The present disclosure relates to a substrate processing apparatus, a method of manufacturing a semiconductor device, and use of the substrate processing apparatus.

BACKGROUND

In the related art, as an example of a substrate processing apparatus, a semiconductor manufacturing apparatus for manufacturing a semiconductor device is known. There has been known a vertical type apparatus as an example of the semiconductor manufacturing apparatus. As a substrate processing apparatus of the vertical type apparatus, there is known an apparatus in which a boat as a substrate holder for holding wafers as substrates in multiple stages is provided in a reaction tube, and a plurality of substrates are processed in a process chamber inside the reaction tube while being held by the substrate holder.

However, in the related art, as for a wafer placed at an end of a process chamber, it may not be possible to sufficiently control in-plane uniformity of a thickness of a film formed on the wafer by processing.

SUMMARY

Some embodiments of the present disclosure provide a technique capable of locally improving in-plane uniformity of an end product wafer among a plurality of product wafers.

According to one embodiment of the present disclosure, there is provided a technique that includes (a) a process chamber configured to accommodate a plurality of substrates arranged vertically, provided with a product region and a dummy region, which is provided on at least one selected from the group of an upper side of the product region and a lower side of the product region, in the process chamber, and including a main exhauster on a lateral side of the process chamber; (b) a first injector extending vertically within the process chamber on an opposite side from the main exhauster, and configured to supply a first precursor toward the substrates accommodated in the product region and the dummy region; (c) at least one selected from the group of a second injector and a third injector, wherein the second injector is installed on an upstream side of a center of the plurality of substrates accommodated inside the process chamber in a flow of the first precursor and configured to supply an assist gas for diluting the first precursor toward substrates accommodated in the dummy region at a larger amount than substrates accommodated in the product region, and the third injector is installed on a downstream side of the center of the substrates in the flow of the first precursor and configured to supply an inert gas toward the substrates accommodated in the product region and the substrates accommodated in the dummy region; and (d) a fourth injector configured to supply an inert gas only to the dummy region.

BRIEF DESCRIPTION OF DRAWINGS

The accompanying drawings, which are incorporated in and constitute a part of the specification, illustrate embodiments of the present disclosure.

FIG. 1 is a front view showing a substrate processing apparatus according to an embodiment of the present disclosure which is partially cut on a vertical plane extending along a depth direction.
FIG. 2 is a cross-sectional view taken along line 2-2 in FIG. 1, showing the substrate processing apparatus according to the present embodiment which is cut in a horizontal direction.
FIG. 3 is a cross-sectional view taken along line 3-3 in FIG. 2, showing the processing container of the substrate processing apparatus according to the present embodiment which is cut on a vertical plane extending along a width direction.
FIG. 4 is a side view showing a main exhaust slit and a sub-exhaust slit formed in the inner tube of the processing container of the substrate processing apparatus according to the present embodiment, which are viewed from the outer tube side.
FIG. 5 is a front view showing the injection holes of nozzles provided in the substrate processing apparatus according to the present embodiment.

FIG. 6 is a cross-sectional view showing an inclined injection hole opened obliquely upward.

FIG. 7 is a block diagram showing a control system of a control part of the substrate processing apparatus according to the present embodiment.

FIG. 8 is a flowchart showing a substrate processing process according to the present embodiment.

FIG. 9 is a timing chart showing a film-forming sequence in the substrate processing process according to the present embodiment.

FIG. 10A is a graph showing the film thickness of a product wafer of a semiconductor device manufactured by a substrate processing apparatus according to a comparative example, and FIG. 10B is a graph showing the film thickness of a product wafer of a semiconductor device manufactured by the substrate processing apparatus according to the present embodiment.

FIG. 11 is a cross-sectional view showing the substrate processing apparatus according to a first modification, which is cut in the horizontal direction at the same height as line 2-2 in FIG. 1.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

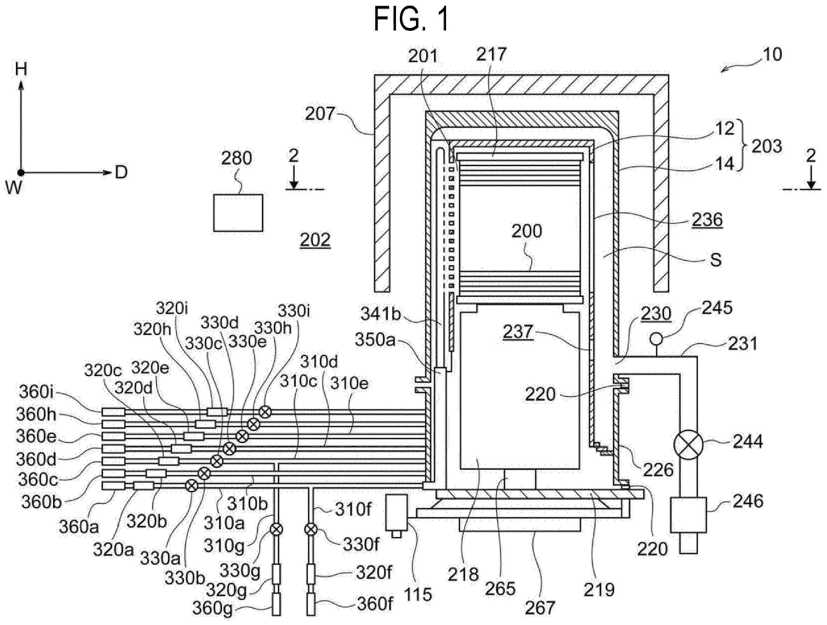

Embodiments of the present disclosure will be described below mainly with reference to FIGS. 1 to 11. The drawings used in the following description are all schematic. The dimensional relationship of respective elements, the ratio of respective elements, and the like shown in the drawings do not necessarily match the actual ones. In addition, the dimensional relationship of respective elements, the ratio of respective elements, and the like do not necessarily match between a plurality of drawings.

Moreover, unless otherwise specified in the specification, each element is not limited to one, and a plurality of elements may exist. Further, in the drawings, substantially the same elements are denoted by the same reference numerals, and the redundant description thereof is omitted in the specification.

The term "wafer" used herein may refer to a wafer itself or a stacked body of a wafer and a predetermined layer or film formed on the surface of the wafer. The phrase "a surface of a wafer" used herein may refer to a surface of a wafer itself or a surface of a predetermined layer or the like formed on a wafer. The expression "a predetermined layer is formed on a wafer" used herein may mean that a predetermined layer is directly formed on a surface of a wafer itself or that a predetermined layer is formed on a layer or the like formed on a wafer. The term "substrate" used herein may be synonymous with the term "wafer."

The term "agent" used in the present disclosure includes at least one selected from the group of a gaseous substance and a liquid substance. The liquid substance includes a mist substance. That is, a cleaning agent and an oxidizing agent may include a gaseous substance, a liquid substance such as a mist substance or the like, or both of them.

In this specification, the expression of a numerical range such as "1 to 2000 Pa" means that a lower limit and an upper limit are included in the range. Therefore, for example, "1 to 2000 Pa" means "1 Pa or more and 2000 Pa or less." The same applies to other numerical ranges. When "0" is included in a numerical value, "0" means a state in which a substance such as a gas or the like is not supplied. For example, when 0 slm is included in a gas supply flow rate, 0 slm means a state in which no gas is supplied. This also applies to other substances in the following descriptions.

<Overall Configuration of Substrate Processing Apparatus>

First, the overall configuration of a substrate processing apparatus 10 according to the present embodiment will be described with reference to FIGS. 1 to 10. An up-and-down direction H of the apparatus indicates a vertical direction, a width direction W of the apparatus indicates a horizontal direction, and a depth direction D of the apparatus indicates a horizontal direction.

As shown in FIG. 1, the substrate processing apparatus 10 includes a controller 280 for controlling each part and a process furnace 202. The process furnace 202 includes a heater 207 as a heating means. The heater 207 has a cylindrical shape and is supported by a heater base (not shown) so as to be vertically installed in the vertical direction of the apparatus. The heater 207 also functions as an activation mechanism that thermally activates a processing gas. Details of the controller 280 will be described later.

Inside the heater 207, a reaction tube 203, which constitutes a reaction container, is vertically arranged concentrically with the heater 207. The reaction tube 203 is made of a heat-resistant material such as quartz ($SiO_2$) or silicon carbide (SiC). The substrate processing apparatus 10 is of a so-called hot wall type.

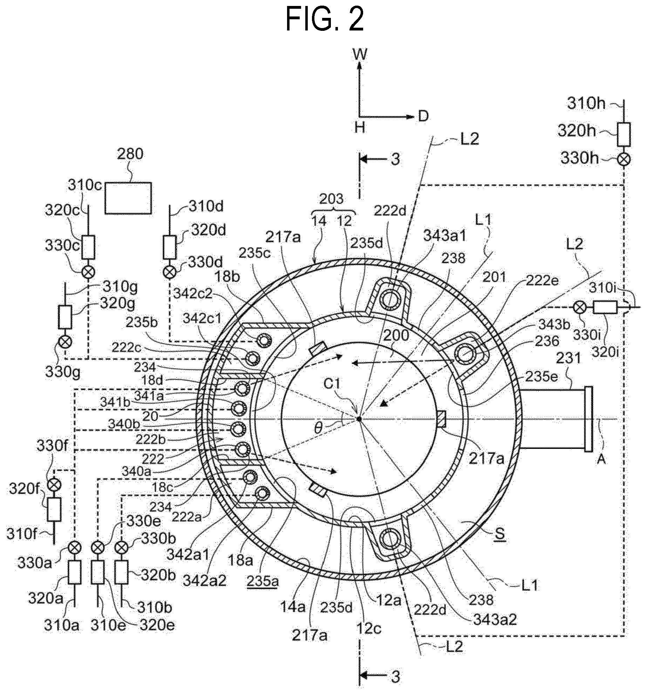

As shown in FIG. 2, the reaction tube 203 includes an inner tube 12 of a cylindrical shape and an outer tube 14 of a cylindrical shape, which is installed to surround the inner tube 12. That is, the outer tube 14 constitutes the reaction tube 203 together with the inner tube 12. The outer tube 14 surrounds the inner tube 12, so that a gap as an exhaust space S is formed between the tubes. The inner tube 12 is arranged concentrically with the outer tube 14. The inner tube 12 is an example of a tube member.

The inner tube 12 has a side wall as a cylindrical portion, which has a closed upper portion and accommodates a plurality of substrates therein. Specifically, as shown in FIG. 1, the inner tube 12 is formed in a roofed shape having an open lower end and an upper end closed with a flat wall. The outer tube 14 is also formed in a roofed shape with a lower end opened and an upper end closed by a flat wall. Further, in the exhaust space S formed between the inner tube 12 and the outer tube 14, as shown in FIG. 2, a supply buffer 222 is formed as a nozzle chamber. Details of the supply buffer 222 will be described later.

Inside the inner tube 12, as shown in FIG. 1, a process chamber 201 is formed for processing wafers 200 as substrates. In addition, the process chamber 201 is configured to capable of accommodating a boat 217, which is an example of a substrate holder capable of holding the wafers 200 in a horizontal posture and in multiple stages in the vertical direction. The inner tube 12 surrounds the accommodated wafers 200. The wafers 200 are arranged inside the cylindrical portion of the inner tube 12 along an axial direction of the cylindrical portion. Details of the inner tube 12 will be described later.

A lower end of the reaction tube 203 is supported by a cylindrical manifold 226. The manifold 226 is made of a metal such as a nickel alloy or stainless steel, or made of a heat-resistant material such as $SiO_2$ or SiC. A flange is formed at an upper end of the manifold 226, and a lower end of the outer tube 14 is installed on the flange. A sealing member 220 such as an O-ring or the like is arranged between the flange and the lower end of the outer tube 14 to keep the inside of the reaction tube 203 in an airtight state.

A seal cap 219 is airtightly installed to the lower end opening of the manifold 226 via the sealing member 220 such as an O-ring or the like so as to airtightly close the lower end opening of the reaction tube 203, that is, the opening of the manifold 226. The seal cap 219 is made of a metal such as a nickel alloy or stainless steel, and is formed in a disc shape. The seal cap 219 may be configured so that its outer side is covered with a heat-resistant material such as $SiO_2$ or SiC.

A boat support 218 for supporting the boat 217 is provided on the seal cap 219. The boat support 218 is made of a heat-resistant material such as $SiO_2$ or SiC, and functions as a heat insulator.

A boat 217 is installed upright on a boat support 218. The boat 217 is made of a heat-resistant material such as $SiO_2$ or SiC. As shown in FIG. 2, the boat 217 includes a bottom plate (not shown) fixed to the boat support 218, a top plate disposed above the bottom plate, and a plurality of pillars 217a arranged between the bottom plate and the top plate.

The boat 217 holds a plurality of wafers 200 to be processed in the process chamber 201 inside the inner tube 12. As shown in FIG. 2, the wafers 200 are held at predetermined intervals in a horizontal posture, and are supported by the pillars 217a of the boat 217 with the centers thereof aligned with each other. The stacking direction of the wafers 200 is an axial direction of the reaction tube 203. That is, the centers of the substrates are aligned with the central axis of the boat 217, and the central axis of the boat 217 coincides with the central axis of the reaction tube 203.

A rotator 267 for rotating the boat is installed below the seal cap 219. A rotary shaft 265 of the rotator 267 is connected to the boat support 218 through the seal cap 219. The rotator rotates the boat 217 via the boat support 218 to thereby rotate the wafers 200.

The seal cap 219 is vertically moved up and down by an elevator 115 as an elevating mechanism installed outside the reaction tube 203, so that the boat 217 can be loaded into and out of the process chamber 201.

In the manifold 226, a plurality of nozzle supports which supports gas nozzles 340a, 340b, 341a, 341b, 342c2, 343a1, 343a2, 343b, 342a2, 342c1 and 342a1 for supplying gases into the process chamber 201 are installed so as to penetrate the manifold 226. In the present embodiment, four nozzle supports are installed. In FIG. 1, the gas nozzle 341b and the nozzle support 350a are merely illustrated. The nozzle support are made of a material such as, for example, a nickel alloy or stainless steel.

Gas supply pipes 310a to 310i for supplying gases into the process chamber 201 are connected to one ends of the nozzle supports, respectively. The gas nozzles 340a, 340b, 341a, 341b, 342c2, 343a1, 343a2, 343b, 342a2, 342c1 and 342a1 are connected to the other ends of the nozzle supports, respectively. The gas nozzles 340a, 340b, 341a, 341b, 342c2, 343a1, 343a2, 343b, 342a2, 342c1 and 342a1 are made of a heat-resistant material such as $SiO_2$ or SiC. Details of the gas nozzles 340a, 340b, 341a, 341b, 342c2, 343a1, 343a2, 343b, 342a2, 342c1 and 342a1 will be described later.

(Gas supply pipe)

As shown in FIG. 2, the gas supply pipes 310a and 310f communicate with the first gas nozzles 340a, 340b, 341a and 341b via the nozzle supports. Further, the gas supply pipe 310e communicates with the seventh gas nozzle 342a1 via the nozzle support. In addition, the gas supply pipes 310c and 310g communicate with the sixth gas nozzle 342c1 via the nozzle support.

Further, the gas supply pipe 3 10d communicates with the second gas nozzle 342c2 via the nozzle support 350d. Further, the gas supply pipe 310b communicates with the fifth gas nozzle 342a2 via the nozzle support. Further, the gas supply pipe 310h communicates with the third gas nozzles 343a1 and 343a2 via the nozzle supports. Further, the gas supply pipe 310i communicates with the fourth gas nozzle 343b via the nozzle support.

In the gas supply pipe 310a, a precursor gas supply source 360a for supplying a first precursor gas as a processing gas, a mass flow controller (MFC) 320a as an example of a flow rate controller, and a valve 330a as an opening/closing valve are installed sequentially from an upstream side in a gas flow direction.

In the gas supply pipe 310b, an assist gas supply source 360b for supplying an assist gas as a processing gas, an MFC 320b, and a valve 330b are installed sequentially from an upstream side. In the gas supply pipe 310c, a precursor gas supply source 360c for supplying a second precursor gas as a processing gas, an MFC 320c, and a valve 330c are installed sequentially from an upstream side. In the gas supply pipe 310d, an assist gas supply source 360d for supplying an assist gas as a processing gas, an MFC 320d, and a valve 330d are installed sequentially from an upstream side.

In the gas supply pipe 310e, an assist gas supply source 360e for supplying an assist gas as a processing gas, an MFC 320e, and a valve 330e are installed sequentially from an upstream side. Further, in the gas supply pipe 310h, an inert gas supply source 360h for supplying an inert gas as a processing gas, an MFC 320h, and a valve 330h are installed sequentially from an upstream side. In addition, in the gas supply pipe 310e, an inert gas supply source 360i for supplying an inert gas as a processing gas, an MFC 320i, and a valve 330i are installed sequentially from an upstream side.

A gas supply pipe 3 10f for supplying an inert gas is connected to the gas supply pipe 310a on a downstream side of the valve 330a. In the gas supply pipe 310f, an inert gas supply source 360f for supplying an inert gas as a processing gas, an MFC 320f, and a valve 330f are installed sequentially from the upstream side.

A gas supply pipe 310g for supplying an inert gas is connected to the gas supply pipe 310c on a downstream side of the valve 330c. In the gas supply pipe 310g, an inert gas supply source 360g for supplying an inert gas as a processing gas, an MFC 320g, and a valve 330g are installed sequentially from an upstream side. Assist gas supply sources 360b, 360d, and 360e and inert gas supply sources 360f, 360g, 360h, and 360i are connected to a common supply source.

(Supply System for First Gas Nozzles 340a, 340b, 341a and 341b)

A first precursor gas supply system is mainly composed of the gas supply pipe 310a, the gas supply pipe 310f, the MFC 320a, the MFC 320f, the valve 330a, and the valve 330f. The precursor gas supply source 360a and the inert gas supply source 360f may be included in the first precursor gas supply system.

(Supply System for Second Gas Nozzle 342c2)

An assist gas supply system for only an upper dummy region of two side dummy regions, which will be described later, is mainly composed of the gas supply pipe 310d, the MFC 320d, and the valve 330d. The assist gas supply source 360d may be included in the assist gas supply system.

(Supply System for Third Gas Nozzles 343a1 and 343a2)

An inert gas supply system for both a product region and side dummy regions is mainly composed of the gas supply pipe 310h, the MFC 320h, and the valve 330h. An inert gas supply source 360h may be included in the inert gas supply system.

(Supply System for Fourth Gas Nozzle 343b)

An assist gas supply system for only the side dummy regions is mainly composed of the gas supply pipe 310i, the MFC 320i, and the valve 330i. The inert gas supply source 360i may be included in the inert gas supply system.

(Supply System for Fifth Gas Nozzle 342a2)

An assist gas supply system for only the lower dummy region of the two side dummy regions is mainly composed of the gas supply pipe 310e, the MFC 320e, and the valve 330e. The assist gas supply source 360e may be included in the assist gas supply system.

(Supply System for Sixth Gas Nozzle 342c1)

A second precursor gas supply system is mainly composed of the gas supply pipe 310c, the gas supply pipe 310g, the MFC 320c, the MFC 320g, the valve 330c, and the valve 330g. The precursor gas supply source 360c and the inert gas supply source 360g may be included in the second precursor gas supply system.

(Supply System for Seventh Gas Nozzle 342a1)

An assist gas supply system for both the product region and the side dummy regions is mainly composed of the gas supply pipe 310b, the MFC 320b, and the valve 330b. The assist gas supply source 360b may be included in the assist gas supply system.

(Exhaust System)

A main exhaust port 230 is formed in the outer tube 14 of the reaction tube 203. The main exhaust port 230 is formed below the exhaust port 237 of the inner tube. A main exhaust slit 236 as a main exhauster is formed in the inner tube 12 of the reaction tube 203. That is, the reaction tube 203 has a main exhaust slit 236 on the lateral side thereof.
As shown in FIG. 2, the main exhaust port 230 is arranged so as to be located on the same straight line as the main exhaust slit 236 in a plan view. Although the illustration is omitted, a pair of sub-exhaust ports is formed in the outer tube 14 of the reaction tube 203. As shown in FIG. 2, each of the pair of sub-exhaust ports is arranged so as to be located on the same straight line as the corresponding sub-exhaust slit 238 in a plan view. The sub-exhaust slit 238 corresponds to the sub-exhauster of the present disclosure.
The main exhaust port 230 and the pair of sub-exhaust ports bring the exhaust space S and the outside of the reaction tube 203 into communication with each other. The main exhaust port 230 and the pair of sub-exhaust ports correspond to the exhaust ports of the present disclosure. A main exhaust duct 231 for sending a precursor gas to the outside is connected to the main exhaust port 230. In addition, as shown in FIG. 2, a sub-exhaust duct 232 for sending a precursor gas to the outside is connected to the sub-exhaust port.
A vacuum pump 246 as a vacuum-exhaust device is connected to the main exhaust duct 231 via a pressure sensor 245 for detecting the pressure inside the process chamber 201 and an APC (Auto Pressure Controller) valve 244 as a pressure regulator. The main exhaust duct 231 on a downstream side of the vacuum pump 246 is connected to a waste gas treatment device (not shown) or the like. By controlling an output of the vacuum pump 246 and an opening degree of the APC valve 244, the process chamber 201 can be vacuum-exhausted such that the pressure inside the process chamber 201 is set to a predetermined pressure (i.e., degree of vacuum).
Although not shown, as in the main exhaust duct 231, a vacuum pump is also connected to the sub-exhaust duct 232 via a pressure sensor and an APC valve. The sub-exhaust duct 232 on the downstream side of the vacuum pump is connected to the waste gas treatment device (not shown) or the like.
A main exhaust system is mainly composed of the main exhaust duct 231, the APC valve 244, and the pressure sensor 245. The vacuum pump 246 may be included in the main exhaust system. Further, a sub-exhaust system is mainly composed of the sub-exhaust duct 232, the APC valve (not shown) connected to the sub-exhaust duct 232, and the pressure sensor (not shown) connected to the sub-exhaust duct 232. The vacuum pump (not shown) connected to the sub-exhaust duct 232 may be included in the sub-exhaust system.
A temperature sensor (not shown) as a temperature detector is installed inside the reaction tube 203. The temperature inside the process chamber 201 is controlled to have a desired temperature distribution by adjusting the electric power supplied to the heater 207 based on the temperature information detected by the temperature sensor.
In this specification, a processing temperature refers to a temperature of the wafer 200 or a temperature inside the process chamber 201, and a processing pressure refers to a pressure inside the process chamber 201. Moreover, a processing time refers to a time during which the processing is continued. These also apply to the following descriptions.
With this configuration, in the process furnace 202, the boat 217 on which the plurality of wafers 200 to be batch-processed are stacked in multiple stages is loaded into the process chamber 201 by the boat support 218. Then, the wafers 200 loaded into the process chamber 201 are heated to a predetermined temperature by the heater 207. The apparatus having such a process furnace is called a vertical batch apparatus. The wafers accommodated in the process chamber can be classified into product wafers and side dummy wafers. The product wafers refer to wafers used to actually manufacture semiconductor devices such as ICs or the like. The product wafers are arranged at a center portion of the entire wafer arrangement region in a vertical direction. On the other hand, the side dummy wafers refer to wafers used in place of the product wafers, and are arranged at positions where a quality of the product wafers cannot be secured, for example, at both ends of the entire wafer arrangement region with the product wafer arrangement region interposed therebetween.

(Supply Buffer)

As shown in FIG. 2, the supply buffer 222 is a region provided on the side wall of the cylindrical portion of the inner tube 12 and protruding outward from the side wall. The supply buffer 222 is divided into three portions along a circumferential direction of the cylindrical portion by partition walls 18c and 18d.

First gas nozzles 340a, 340b, 341a and 341b for supplying a first precursor gas are installed in a central portion 222b among the divided portions of the supply buffer 222. At a boundary position between the central portion 222b of the supply buffer 222 and the cylindrical portion, a sector is formed by an imaginary arc, which connects both circumferential ends of the cylindrical portion, and a center C1 of the wafer 200. In the present embodiment, a central angle θ of the sector is less than 30 degrees. In the present disclosure, the central angle of the sector may be set arbitrarily.

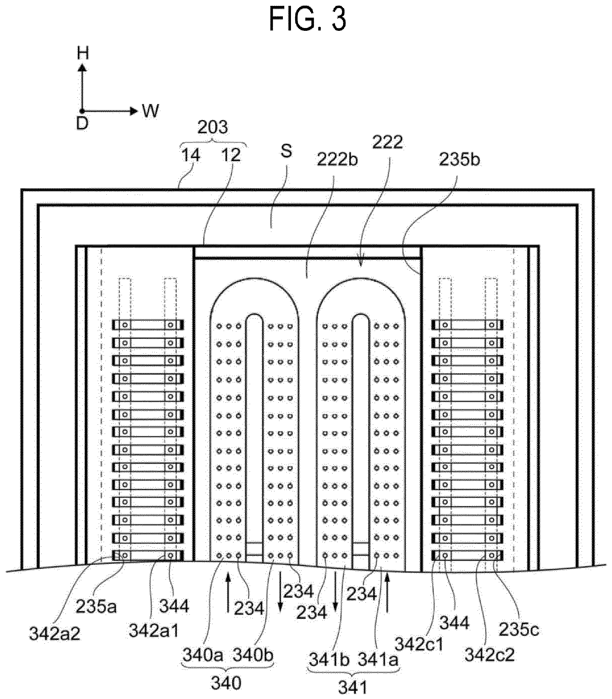

As shown in FIG. 3, a supply slit 235b is formed in the central portion 222b of the supply buffer 222. The supply slit 235b is opened over the entire vertical direction H and the entire width direction W of the apparatus in the central portion 222b. Therefore, the entirety of the first gas nozzles 340a, 340b, 341a and 341b in the vertical direction H of the apparatus and the entirety of the first gas nozzles 340a, 340b, 341a and 341b in the width direction W of the apparatus face the wafers 200 arranged inside the cylindrical portion.

(Exhaust Slit)

As shown in FIG. 2, a plurality of exhaust slits including a main exhaust slit 236 and sub-exhaust slits 238 are formed in the side wall of the cylindrical portion. The exhaust slits are used to exhaust the precursor gas from the inside of the cylindrical portion. In the present embodiment, the number of exhaust slits is three including one main exhaust slit 236 and two sub-exhaust slits 238. In the present disclosure, the number of exhaust slits may be at least two or more.

(Main Exhaust Slit)

The main exhaust slit 236 is formed in the side wall of the cylindrical portion on a side opposite to the supply buffer 222 with respect to the center C1 of the wafer 200. In the present disclosure, the main exhaust slit 236 may not be need.

(Sub-exhaust Slit)

The two sub-exhaust slits 238 are opened on both sides of an imaginary vertical plane A defined inside the cylindrical portion. As shown in FIG. 2, the imaginary vertical plane A is defined so as to pass through a circumferential center of the cylindrical portion and an axis of the cylindrical portion at a boundary between the supply buffer 222 and the cylindrical portion in a plan view. The axis of the cylindrical portion overlaps with the center of the wafer 200.

The two sub-exhaust slits 238 as a pair of exhaust slits are arranged at the same height as the main exhaust slit 236 with the main exhaust slit 236 interposed therebetween. A first imaginary line L1, which connects the center of each of the sub-exhaust slits 238 and the center C1 of the wafer 200 in a plan view, is defined. In the present embodiment, an angle between the first imaginary line L1 and the imaginary vertical plane A is an obtuse angle. This angle is measured at the supply buffer 222 side as a starting point. In the present disclosure, the angle between the first imaginary line L1 and the imaginary vertical plane A 1 is not limited to the obtuse angle.

As shown in FIG. 2, a width of each of the two sub-exhaust slits 238 in the circumferential direction of the cylindrical portion is smaller than a width of the main exhaust slit 236. In the present disclosure, the width of the sub-exhaust slit 238 may also be larger than or equal to the width of the main exhaust slit 236.

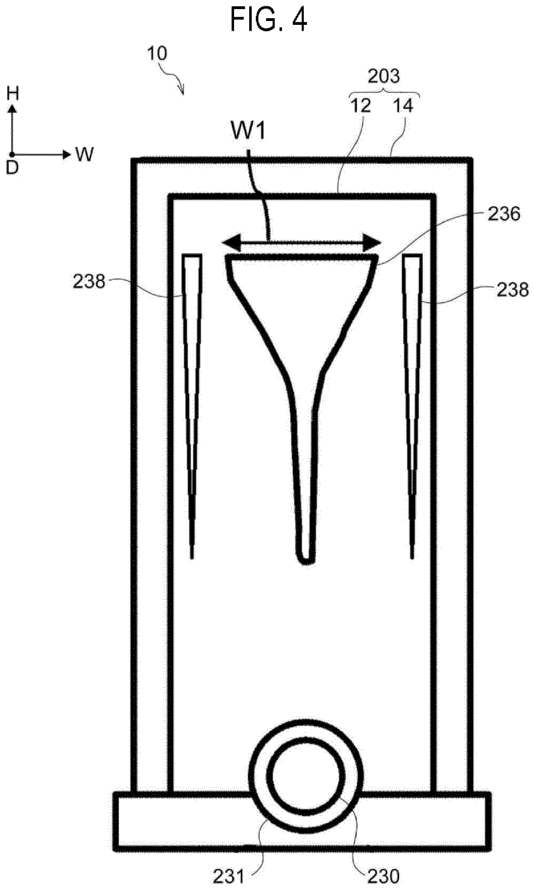

As shown in FIG. 4, in this embodiment, an opening width W1 of the main exhaust slit 236 along the circumferential direction of the cylindrical portion becomes narrower along a direction from a side opposite to the main exhaust port 230 (that is, the upper side in FIG. 4) toward the main exhaust port 230 (that is, the lower side in FIG. 4) along the axial direction of the cylindrical portion. Similarly, an opening width of each of the pair of sub-exhaust slits 238 along the circumferential direction of the tubular portion becomes narrower along a direction from a side opposite to the sub-exhaust port toward the sub-exhaust port along the axial direction of the tubular portion.

In the present disclosure, the opening widths of the main exhaust slit 236 and the pair of sub-exhaust slits 238 along the circumferential direction of the cylindrical portion may be set arbitrarily. An illustration of a counter buffer is omitted in FIG. 4 for the ease of viewing. The counter buffer will be described later.

<Main Part Configuration>

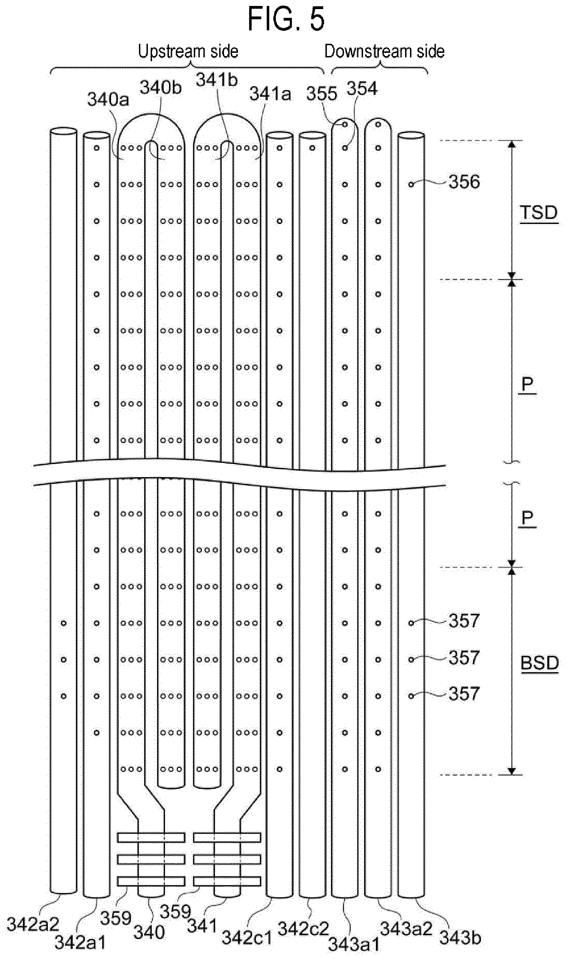

Next, the respective gas nozzles in the substrate processing apparatus 10 according to the present embodiment will be specifically described. The arrangement positions of the gas nozzles 340a, 340b, 341a, 341b, 342c2, 343a1, 343a2, 343b, 342a2, 342c1 and 342a1 in FIG. 5 are schematically shown for the sake of description and are different from the actual arrangement positions inside the process chamber 201.

(Product Region and Side Dummy Region)

First, as shown in FIG. 5, a product region P in which product wafers are arranged, and an upper dummy region TSD and lower dummy region BSD in which side dummy wafers are arranged are provided in the process chamber 201. In the present embodiment, a case is illustrated where there are provided two side dummy regions, that is, an upper dummy region TSD, which is a region in which upper side dummy wafers are arranged, and a lower dummy region BSD, which is a region in which lower side dummy wafers are arranged. However, in the present disclosure, the side dummy region may be provided on at least one selected from the group of the upper side of the product region P and the lower side of the product region P. In that sense, the upper dummy region TSD and the lower dummy region BSD are collectively referred to as a side dummy (SD) region. The product region P, the upper dummy region TSD, and the lower dummy region BSD may be arranged, for example, so as to divide the wafer arrangement region into three equal regions in length.

In the present disclosure, some of the product wafers positioned at an end on the upper dummy region side are referred to as "upper product wafers." Further, some of the product wafers positioned at an end on the lower dummy region side are referred to as "lower product wafers." In addition, the upper product wafers and the lower product wafers are collectively referred to as "end product wafers."

A monitor wafer may be arranged between the side dummy wafer and the product wafer. The monitor wafer is a wafer for monitoring whether or not a desired film has been formed when manufacturing a semiconductor device. In the present disclosure, if the monitor wafer has a pattern similar to that of the product wafer, the monitor region where the monitor wafer is arranged may be included in the product region P. On the other hand, if the monitor wafer does not have a pattern of the same surface area as the product wafer or has no patterns at all, the monitor region where the monitor wafer is arranged may be included in the upper dummy region TSD or the lower dummy region BSD.

When the dummy wafer having a surface area smaller than that of the product wafer is arranged in the SD region, a surface reaction rate slows down, and the processing gas consumption is less than the processing gas consumption in the product region. Furthermore, a top space located above the upper dummy region and a bottom space located below the lower dummy region are formed in the process chamber. For this reason, the processing gas tends to stay as a surplus gas in the top space and the bottom space. This stagnation increases a film thickness on an edge side of the upper and lower product wafers, so that the in-plane uniformity may deteriorate. As a result, inter-plane uniformity may also deteriorate.

In the following descriptions, each of the gas nozzles in the supply buffer 222 will be described by roughly dividing them into a gas injector arranged on an upstream side of the center C1 of the wafer 200 in a plan view in the flow of the first precursor gas, and a gas injector arranged on a downstream side of the center C1 of the wafer 200 in a plan view in the flow of the first precursor gas. Further, in this specification, a position on a boundary line between the upstream side and the downstream side, that is, a position on an imaginary line that includes the center C1 of the wafer 200 and is orthogonal to the imaginary vertical plane A in a plan view, may be included in the upstream side or the downstream side. In addition, an arrangement position of each gas nozzle in a plan view means a position of a center of the cylindrical nozzle.

[Nozzle on Upstream Side]

On the upstream side in the supply buffer 222, there are arranged the first gas nozzles 340a, 340b, 341a and 341b as a first injector, the sixth gas nozzle 342c1 as a sixth injector, the second gas nozzle 342c2 as a second injector, the fifth gas nozzle 342a2 as a fifth injector, and the seventh gas nozzle 342a1 as a seventh injector.

(First Injector)

The first gas nozzles 340a, 340b, 341a and 341b extend in a vertical direction and are arranged to face the main exhaust slit 236 as shown in FIG. 2. The first gas nozzles 340a, 340b, 341a and 341b have injection holes facing both the product region P and the dummy regions. The first gas nozzles 340a, 340b, 341a and 341b supply a first precursor gas from the upstream side to the product wafers and the dummy wafers.

As shown in FIG. 3, the first gas nozzles 340a, 340b, 341a and 341b have three or more injection holes arranged along a direction substantially parallel to a surface of the substrate. In the present disclosure, the number of injection holes of the first gas nozzles 340a, 340b, 341a and 341b may be one or more.

As shown in FIG. 2, the first gas nozzles 340a, 340b, 341a and 341b are a nozzle array in which a plurality of linear circular pipes are arranged along a circumferential direction of the process chamber 201. In the present disclosure, it may not be needed that the first gas nozzles 340a, 340b, 341a and 341b be the nozzle array.

(Return Nozzle)

As shown in FIG. 3, in the present embodiment, the four first gas nozzles 340a, 340b, 341a and 341b are formed by two return nozzles 340 and 341. That is, the lower two gas nozzles 340a and 340b in FIG. 2 among the four first nozzles are formed by one return nozzle 340, and the upper two gas nozzles 341a and 341b in FIG. 2 are formed by another return nozzle 341. In the present disclosure, two nozzles may be formed by only one return nozzle.

Further, in the present disclosure, the number of first nozzles may be one, or may be any plural number of two or more. Moreover, in the present disclosure, the plurality of nozzles need not be return nozzles, and may be, for example, a plurality of independent nozzles.

As shown in FIG. 3, each of the two return nozzles includes a flow pipe and a return pipe through which the precursor gas flows. In the two return nozzles, an upper end of the flow pipe and an upper end of the return pipe are in communication with each other. In the two return nozzles, the return pipes are adjacent to each other and the flow pipes are spaced apart from each other. In the present embodiment, an inner diameter of the flow pipe and an inner diameter of the return pipe are the same. In the present disclosure, the inner diameter of the flow pipe and the inner diameter of the return pipe may also be different.

(Injection Hole)

Each of the flow and return pipes of the two return nozzles 340 and 341 has three or more rows of injection holes 234 extending along a longitudinal direction of the return nozzles. A first precursor gas is injected from the injection holes 234. The first precursor gas is injected radially in a plan view.

In the present disclosure, it may not be needed that the first gas nozzles 340a, 340b, 341a and 341b have three or more rows of injection holes arranged along the vertical direction. The first gas nozzles 340a, 340b, 341a and 341b may have three or more injection holes arranged along the circumferential direction of the cylindrical portion in a plane parallel to the surface of the substrate. Further, in the present disclosure, the number of injection holes may be arbitrarily set to one, two, or four or more.

(Partition Plate)

As shown in FIG. 5, on side surfaces of the first gas nozzles 340a, 340b, 341a and 341b below the lower dummy region BSD, partition plates 359 are installed to protrude from the side surfaces of the first gas nozzles 340a, 340b, 341a and 341b. The partition plates 359 block a vertical gas flow inside the process chamber 201. In the present embodiment, although a shape of the partition plates 359 is exemplified based on a case where the partition plates 359 protrude to the left and right sides of the first gas nozzles 340a, 340b, 341a and 341b in FIG. 5, the present disclosure is not limited thereto. In the present disclosure, the partition plates 359 may be installed on at least a part of a circumference of each of the first gas nozzles 340a, 340b, 341a and 341b.

(Sixth Injector)

The sixth gas nozzle 342c1 includes injection holes facing at least the product region P. The sixth gas nozzle 342c1 supplies a second precursor gas from an upstream side to the product wafers and the dummy wafers.

In the present embodiment, there is illustrated a case where the injection holes of the sixth gas nozzle 342c1 are installed in both the product region P and the dummy region. However, in the present disclosure, the injection holes of the sixth gas nozzle 342c1 may be installed only in the product region P. Further, in the present disclosure, the sixth gas nozzle 342c1 may not be needed.

(Second Injector)

The second gas nozzle 342c2 includes injection holes for supplying an assist gas only to the substrates in the upper dummy region TSD. The number of injection holes of the second gas nozzle 342c2 is one or more. That is, the second gas nozzle 342c2 supplies the assist gas from the upstream side to one or more stages of dummy wafers. In the present embodiment, there is illustrated a case where the number of injection holes of the second gas nozzle 342c2 is one. However, in the present disclosure, the number of injection holes of the second gas nozzle 342c2 may be arbitrarily set to one or more.

In the present disclosure, the second gas nozzle 342c2 injects a larger amount of assist gas to the side dummy regions than to the product region P. In the present embodiment, there is illustrated a case where the injection holes of the second gas nozzles 342c2 are installed only in the upper dummy region TSD. However, in the present disclosure, the injection holes of the second gas nozzles 342c2 may be installed on both the product region P and the side dummy regions.

When the injection holes are installed on both the product region P and the side dummy regions, for example, the number of injection holes on the side of the side dummy region is set to be larger than the number of injection holes on the side of the product region P so that a larger amount of assist gas is injected to the side dummy region than to the product region P. Alternatively, for example, the number of injection holes arranged in one stage may be changed so that the number of injection holes arranged in one stage on the side of the side dummy region is three and the number of injection holes arranged in one stage on the side of the product region P is one.

(Fifth Injector)

The fifth gas nozzle 342a2 is arranged on the upstream side of the flow of the first precursor gas from the center of the substrate, and includes injection holes for supplying the assist gas only to the substrate in the lower dummy region BSD. The number of injection holes of the fifth gas nozzle 342a2 is two or more. That is, the fifth gas nozzle 342a2 supplies the assist gas from the upstream side to two or more stages of dummy wafers. In the present embodiment, there is illustrated a case where the number of injection holes of the fifth gas nozzle 342a2 is three. However, in the present disclosure, the number of injection holes of the fifth gas nozzle 342a2 may be arbitrarily set to two or more.

In the present embodiment, by arranging two nozzles, that is, the second gas nozzle 342c2 and the fifth gas nozzle 342a2, on the upstream side, it is possible to adjust a film thickness of each of the wafers and, consequently, adjust the inter-plane uniformity of all the wafers. In the present disclosure, the fifth gas nozzle 342a2 may not be needed. If the fifth gas nozzle 342a2 is not installed, the second gas nozzle 342c2 may have both injection holes facing the upper dummy region TSD and injection holes facing the lower dummy region BSD. Further, in the present disclosure, the second gas nozzle 342c2 may include only the injection holes facing the lower dummy region BSD.

(Seventh Injector)

The seventh gas nozzle 342a1 includes injection holes facing at least the product region P. In the present embodiment, there is illustrated a case where the injection holes of the seventh gas nozzle 342a1 are installed in both the product region P and the side dummy regions. In the present disclosure, the injection holes of the seventh gas nozzle 342a1 may be installed only in the product area P. Further, in the present disclosure, the seventh gas nozzle 342a1 may not be needed.

The seventh gas nozzle 342a1 supplies an assist gas from the upstream side to the product wafers and the dummy wafers. The assist gas of the seventh gas nozzle 342a1 is a gas different from both the first precursor gas and the second precursor gas. The in-plane uniformity of each of the product wafers can be adjusted by the seventh gas nozzle 342a1.

The seventh gas nozzle 342a1 supplies the assist gas when the first precursor gas is supplied from the first gas nozzles 340a, 340b, 341a and 341b and the second precursor gas is supplied from the sixth gas nozzle 342c1.

Moreover, in the present embodiment, the sixth gas nozzle 342c1 and the seventh gas nozzle 342a1 are arranged such that the first gas nozzles 340a, 340b, 341a and 341b are interposed therebetween. Further, the seventh gas nozzle 342a1 supplies the assist gas when the first precursor gas, which is a precursor gas containing a Group 14 element, is supplied from the first gas nozzles 340a, 340b, 341a and 341b. The precursor gas containing a Group 14 element is, for example, a gas containing C, Si, Ge, Sn, Pb, or the like. In the present disclosure, the first precursor gas may be a precursor gas containing an element other than the Group 14 element.

[Nozzle on Downstream Side]

On the downstream side in the supply buffer 222, third gas nozzles 343a1 and 343a2 as a third injector and a fourth gas nozzle 343b as a fourth injector are arranged.

(Third Injector)

The third gas nozzles 343a1 and 343a2 include injection holes facing both the product region P and the dummy regions. The third gas nozzles 343a1 and 343a2 supply an inert gas to the product wafers and the dummy wafers from the downstream side. The in-plane uniformity of each of the product wafers can be adjusted by the third gas nozzles 343a1 and 343a2.

In the present embodiment, the third gas nozzles 343a1 and 343a2 are installed on both sides of an imaginary vertical plane A, which connects the main exhaust port and the center of the substrate. In addition, in the present disclosure, the number of third gas nozzles 343a1 and 343a2 is not limited to one pair, and may be one, or three or more.

The third gas nozzles 343a1 and 343a2 are installed as counter nozzles at positions where an angle between the second imaginary line L2, which connects the injection directions of the third gas nozzles 343a1 and 343a2 and the center C1 of the wafer 200, and the imaginary vertical plane A (with the supply buffer 222 side as a starting point) is an obtuse angle in a plan view. The third gas nozzles 343a1 and 343a2 as the counter nozzles are accommodated inside counter buffers 222d, respectively. Just like the supply buffer 222, the counter buffers 222d are regions installed on the side wall of the cylindrical portion of the inner tube 12 and protruding outward from the side wall.

In the present embodiment, there is illustrated a case where both the second gas nozzle 342c2 and the third gas nozzles 343a1 and 343a2 are installed. In the present disclosure, it may not be needed that both the second gas nozzle 342c2 and the third gas nozzles 343a1, 343a2 are installed. At least one of the second gas nozzle 342c2 and the third gas nozzles 343a1 and 343a2 may be installed.

(Horizontal Injection Hole and Inclined Injection Hole)

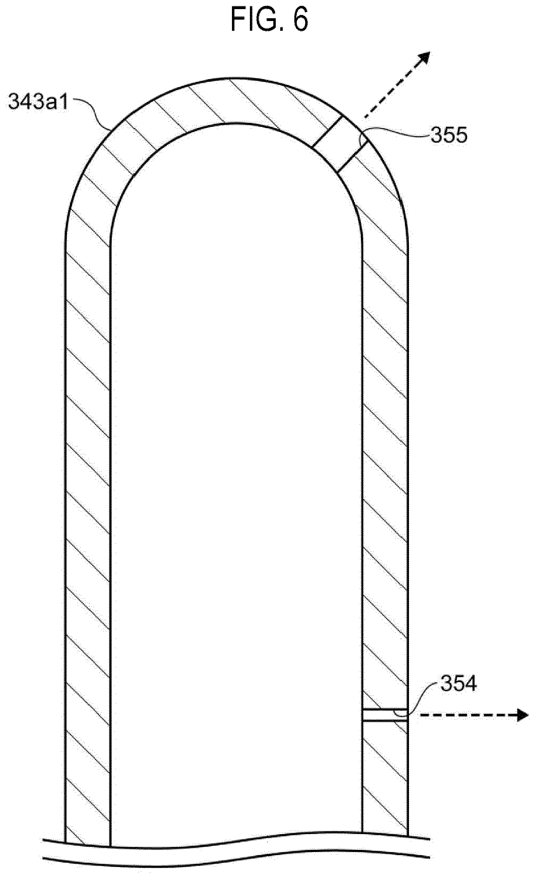

As shown in FIG. 5, the third gas nozzles 343a1 and 343a2 include a plurality of horizontal injection holes 354 and an inclined injection hole 355. As shown in FIG. 6, the horizontal injection holes 354 are opened substantially parallel to the surface of the substrate. The inclined injection hole 355 is installed at a position higher than the uppermost horizontal injection hole 354 among the plurality of horizontal injection holes 354. The inclined injection hole 355 is opened obliquely upward in FIG. 6. In the present disclosure, the number of inclined injection holes 355 is not limited to one, and may be plural.

(Fourth Injector)

The fourth gas nozzle 343b includes both injection holes facing the upper dummy region TSD and injection holes facing the lower dummy region BSD. The injection holes facing the product region P1 are not formed in the fourth gas nozzle 343b. That is, the fourth gas nozzle 343b injects an inert gas only to the upper dummy region TSD and the lower dummy region BSD. In the present disclosure, the number of injection holes of the fourth gas nozzle 343b may be arbitrarily set in each of the upper dummy region TSD and the lower dummy region BSD.

The fourth gas nozzles 343b is installed as a counter nozzle at a position where an angle between the second imaginary line L2, which connects the center of the fourth gas nozzles 343b and the center C1 of the wafer 200, and the imaginary vertical plane A (with the supply buffer 222 side as a starting point) is an obtuse angle in a plan view. That is, the fourth gas nozzle 343b is arranged outside the imaginary vertical plane A on the downstream side of the flow of the first precursor gas. In the present disclosure, the arrangement position of the fourth gas nozzle 343b is arbitrary. The fourth gas nozzle 343b as the counter nozzle are accommodated inside a counter buffer 222e. Just like the supply buffer 222, the counter buffer 222e is a region installed on the side wall of the cylindrical portion of the inner tube 12 and protruding outward from the side wall.

As shown in FIG. 2, the fourth gas nozzle 343b injects the inert gas toward a region which is an outer side region from the center C1 of the wafer 200 and is a region on an upstream side between the fourth gas nozzle 343b and the peripheral edge of the wafer 200 on the side where the fourth gas nozzle 343b is arranged. Specifically, in FIG. 2, the direction toward the center C1 of the wafer 200 is illustrated by a dotted line as the injection direction of the fourth gas nozzle 343b. However, just like the injection direction of the fourth gas nozzle 343b illustrated by the one-dot chain line in FIG. 2, the injection direction of the fourth gas nozzle 343b may be set so as to direct toward the upstream side of the center C1 of the wafer 200 without the injection direction intersecting the imaginary vertical plane A on the downstream side. In the present disclosure, the injection direction of the fourth gas nozzle 343b is arbitrary.

The fourth gas nozzle 343b is installed adjacent to one of the third gas nozzles 343a1 and 343a2 located on the upper side in FIG. 2. In this specification, the phrase "nozzles are adjacent to each other" includes a case where an exhauster is installed between adjacent nozzles.

Further, as shown in FIG. 2, the process chamber 201 includes the sub-exhaust slits 238 between the third gas nozzles 343a1 and 343a2 and the fourth gas nozzle 343b. Further, in the present disclosure, the sub-exhaust slits 238 between the third gas nozzles 343a1 and 343a2 and the fourth gas nozzle 343b may not be needed. Moreover, in the present embodiment, the fourth gas nozzle 343b is arranged at a position closer to the main exhaust slit 236 than the third gas nozzles 343a1 and 343a2. In the present disclosure, the fourth gas nozzle 343b may be farther from the main exhaust slit 236 than the third gas nozzles 343a1 and 343a2.

As shown in FIG. 5, the fourth gas nozzle 343b includes an upper injection hole 356 opened toward at least one of the plurality of substrates accommodated in the upper dummy region TSD excluding the uppermost stage. In addition, the fourth gas nozzle 343b includes lower injection holes 357 opened toward at least two of the plurality of substrates accommodated in the lower dummy region BSD excluding the lowest stage.

In the present disclosure, the arrangement position of the upper injection hole 356 may be the uppermost stage. Further, in the present disclosure, arrangement positions of the lower injection holes 357 may be the lowest stage. Further, in the present disclosure, the lower injection holes 357 may be opened toward only one substrate.

(Diameter of Injection Hole of Fourth Gas Nozzle 343b)

In the present embodiment, a hole diameter of the injection holes of the fourth gas nozzle 343b is preferably 0.8 mm or more and 3.0 mm or less. When the hole diameter is 0.8 mm or more and 3.0 mm or less, it is possible to achieve the in-plane uniformity of about 0.1% on the lower side and the in-plane uniformity of about 0.2% on the upper side.

If the hole diameter of the injection holes of the fourth gas nozzle 343b is less than 0.8 mm, there is a concern that the gas may easily leak from a base of the nozzle due to an increase in an internal pressure of the nozzle. Moreover, when the hole diameter exceeds 3.0 mm, there is a concern that the gas coming out of the injection holes may be discharged upward instead of horizontally due to inertia rising in the nozzle. In addition, a pressure difference between a top side and a bottom side of the nozzle, that is, the difference in injection amount, tends to increase.

(In-plane Uniformity)

A method for measuring in-plane uniformity in the present embodiment will now be described. First, 15 measurement points are set on the wafer to be measured. The 15 measurement points include the center of the wafer and 14 measurement points that differ in radiation direction or distance from the center of the wafer.

Then, the film thickness at each of the 15 measurement points is measured by a known method such as spectroscopic ellipsometry. Further, the average value of the film thicknesses is calculated from the 15 measured values. Then, the in-plane uniformity [%] of the wafer to be measured can be calculated by the following formula using the maximum value, minimum value, and average value of the 15 measured values.

$$\text{In-plane uniformity [\%]} = (\text{maximum value} - \text{minimum value}) \,/\, \text{average value} \times 100$$

The in-plane uniformity in this definition is a non-negative number. The closer to 0, the better the in-plane uniformity.

(Diameter of Injection Hole of Fourth Gas Nozzle 343b)

Next, a diameter of the injection holes of the fourth gas nozzle 343b will be described. If an internal pressure of the fourth gas nozzle 343b has a large effect on the process performance, for example, the gas leaks from the base of the fourth gas nozzle 343b, whereby a gas concentration on a bottom side inside the process chamber 201 tends to change. In order to suppress an influence of the internal pressure of the fourth gas nozzle 343b on the process performance, the hole diameter of the fourth gas nozzle 343b can be adjusted in the present embodiment.

Specifically, the hole diameter of the injection holes of the fourth gas nozzle 343b may be set to 0.8 mm or more and 3.0 mm or less. When the hole diameter is 0.8 mm or more and 3.0 mm or less, it is possible to achieve the in-plane uniformity of the lower product wafers of about 0.1% and the in-plane uniformity of the upper product wafers of about 0.2%.

If the hole diameter is less than 0.8 mm, there is a concern that the gas may easily leak from the base of the nozzle due to the increase in the internal pressure of the nozzle. On the other hand, if the hole diameter exceeds 3.0 mm, there is a concern that the gas coming out of the injection holes may be discharged upward instead of horizontally due to the inertia rising inside the nozzle. In addition, the pressure difference between the top side and the bottom side of the nozzle, that is, the difference in injection amount, tends to increase.

(Controller)

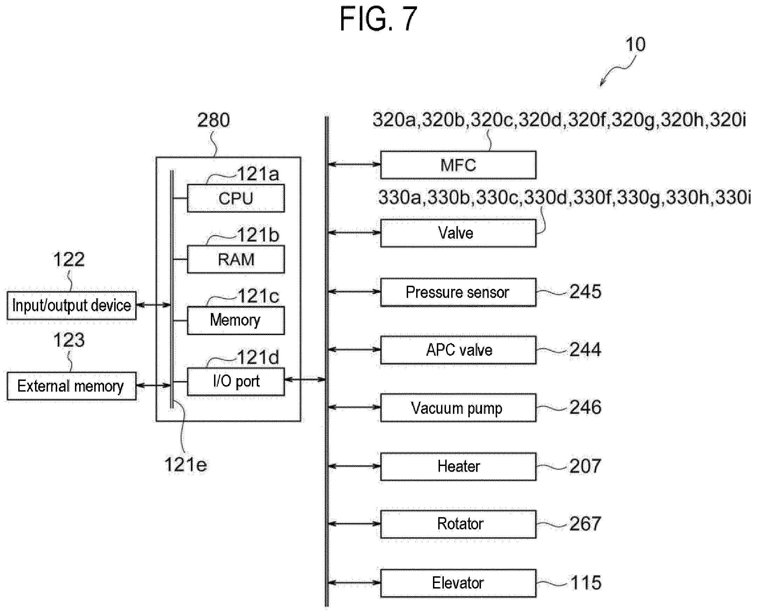

Next, the controller 280 will be described with reference to FIG. 7. FIG. 7 is a block diagram showing the substrate processing apparatus 10. The controller 280 (i.e., control part) of the substrate processing apparatus 10 is configured as a computer. This computer includes a CPU (Central Processing Unit) 121a, a RAM (Random Access Memory) 121b, a memory 121c, and an I/O port 121d.

The RAM 121b, the memory 121c, and the I/O port 121d are configured to exchange data with the CPU 121a via an internal bus 121e. An input/output device 122 configured as, for example, a touch panel or the like is connected to the controller 280.

The memory 121c is composed of, for example, a flash memory, an HDD (Hard Disk Drive), or the like. In the memory 121c, a control program for controlling the operation of the substrate processing apparatus, a process recipe describing procedures and conditions for substrate processing described later, and the like are stored in a readable manner.

The process recipe is a combination that allows the controller 280 to execute each procedure in the substrate processing process, which will be described later, to obtain a predetermined result. The process recipe functions as a substrate processing program. Hereinafter, the process recipe, the control program, and the like are collectively and simply referred to as program.

When the term "program" is used in this specification, it may include only the process recipe, only the control program, or both of them. The RAM 121b is configured as a memory area (i.e., a work area) in which programs and data read by the CPU 121a are temporarily held.

The I/O port 121d is connected to the MFCs 320a to 320i, the valves 330a to 330i, the pressure sensor 245, the APC valve 244, the vacuum pump 246, the heater 207, the temperature sensor, the rotator 267, the elevator 115, and the like.

The CPU 121a is configured to read out the control program from the memory 121c to execute the control program, and read out the process recipe from the memory 121c in response to the input of an operation command from the input/output device 122 or the like.

The CPU 121a is configured to control the flow rate adjustment operation for various gases by the MFCs 320a to 320i, the opening/closing operation of the valves 330a to 330i, and the opening/closing operation of the APC valve 244, in accordance with the content of the process recipe thus read. Further, the CPU 121a is also configured to control the pressure regulation operation by the APC valve 244 based on the pressure sensor 245, the start and stop of the vacuum pump 246, and the temperature adjustment operation of the heater 207 based on the temperature sensor. Further, the CPU 121a is configured to control the rotation of the boat 217 and the rotation speed adjustment operation by the rotator 267, the raising/lowering operation of the boat 217 by the elevator 115, and the like.

The controller 280 is not limited to being configured as a dedicated computer, and may be configured as a general-purpose computer. For example, the controller 280 of the present embodiment can be configured by preparing an external memory device 123 storing the above-described program and installing the program in a general-purpose computer through the use of the external memory device 123. Examples of the external memory device include a magnetic disk such as a hard disk or the like, an optical disk such as a CD or the like, a magneto-optical disks such as an MO or the like, a semiconductor memory such as a USB memory or the like, and so forth.

<Substrate Processing Method>

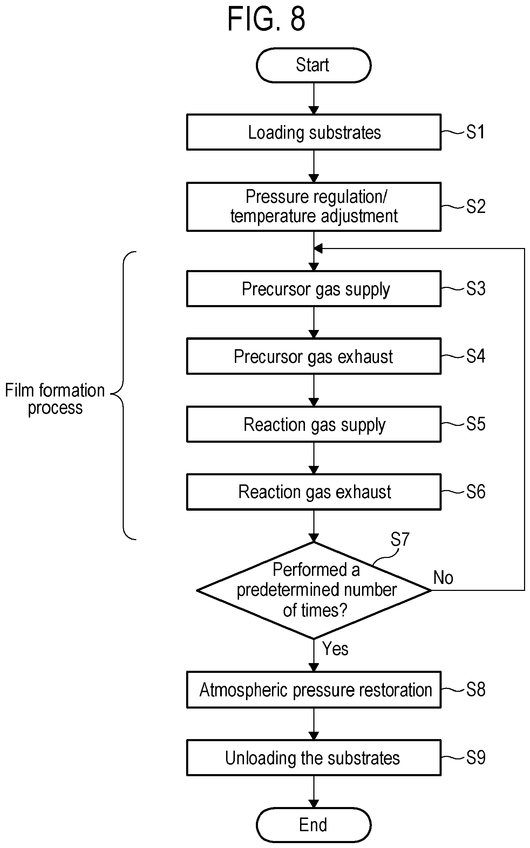

Next, a substrate processing method using the substrate processing apparatus 10 according to the present embodiment will be described with reference to FIG. 8. In the present embodiment, as an example of a process of manufacturing a semiconductor device, there will be described a cycle process in which film processing is performed by alternately supplying a precursor gas and a reaction gas into the process chamber 201.

In the cycle process, a Si nitride film ($Si_3N_4$ film, which is hereinafter also referred to as SiN film) is formed on the substrate by using a silicon (Si) precursor gas as an example of a precursor gas, and using a nitrogen ($N_2$)-containing gas as a reactant.

The SiN film is formed by performing a cycle a predetermined number of times of once or more, the cycle including non-simultaneously performing a film formation step 1 in step S3, a film formation step 2 in step S4, a film formation step 3 in step S5, and a film formation step 4 in step S6, as shown in FIG. 8.

The film formation step 1 is a step of supplying a precursor gas to the wafers 200 inside the inner tube 12. The film formation step 2 is an exhaust step of removing a remaining precursor gas from the inner tube 12. The film formation step 3 is a step of supplying an $N_2$-containing gas as a reaction gas to the wafers 200 inside the inner tube 12. The film formation step 4 is an exhaust step of removing a remaining reaction gas from the inner tube 12.

First, in step S 1 in FIG. 8, the wafers 200 are charged to the boat 217. By loading the boat 217 into the inner tube 12, the wafers 200 are accommodated inside the cylindrical portion of the inner tube 12. Next, in step S2 in FIG. 8, the pressure and temperature inside the inner tube 12 are adjusted after the boat 217 is loaded into the inner tube 12. Next, the four film formation steps 1 to 4 are sequentially executed. Each step will be described in detail below.

(Film Formation Step 1)

In the film formation step 1, at step S3 in FIG. 8, while injecting a first source gas toward the wafers 200 using the first gas nozzles 340a, 340b, 341a and 341b, the injected precursor gas is exhausted to the outside of the cylindrical portion using the main exhaust slit 236 and the two sub-exhaust slits 238.

As the first precursor gas supplied from the gas supply pipe 310a, there may be, for example, a Si source gas. Further, as the first precursor gas, for example, a Si- and halogen-containing gas may be used. As the Si- and halogen-containing gas, inorganic chlorosilane-based gases such as a tetrachlorosilane ($SiCl_4$, abbreviation: STC) gas, a hexachlorodisilane ($Si_2Cl_6$, abbreviation: HCDS) gas, an octachlorotrisilane ($Si_3Cl_8$, abbreviation: OCTS) gas, and the like may be used. One or more of these gases may be used as the Si- and halogen-containing gas. The first precursor gas corresponds to the first precursor of the present disclosure. In addition, in the present disclosure, the first precursor is not limited to a gas, and may be a liquid substance such as a mist substance or the like.

Further, for example, an assist gas such as $N_2$ or the like is injected from the upstream side toward the wafers 200 using the second gas nozzle 342c2, the fifth gas nozzle 342a2, and the seventh gas nozzle 342a1. That is, in the present embodiment, the seventh gas nozzle 342a1 supplies the assist gas when the first precursor gas is supplied from the first gas nozzles 340a, 340b, 341a and 341b. In addition, an inert gas such as $N_2$ or the like is injected from the downstream side toward the wafers 200 using the third gas nozzles 343a1 and 343a2 and the fourth gas nozzle 343b.

(Film Formation Step 2)

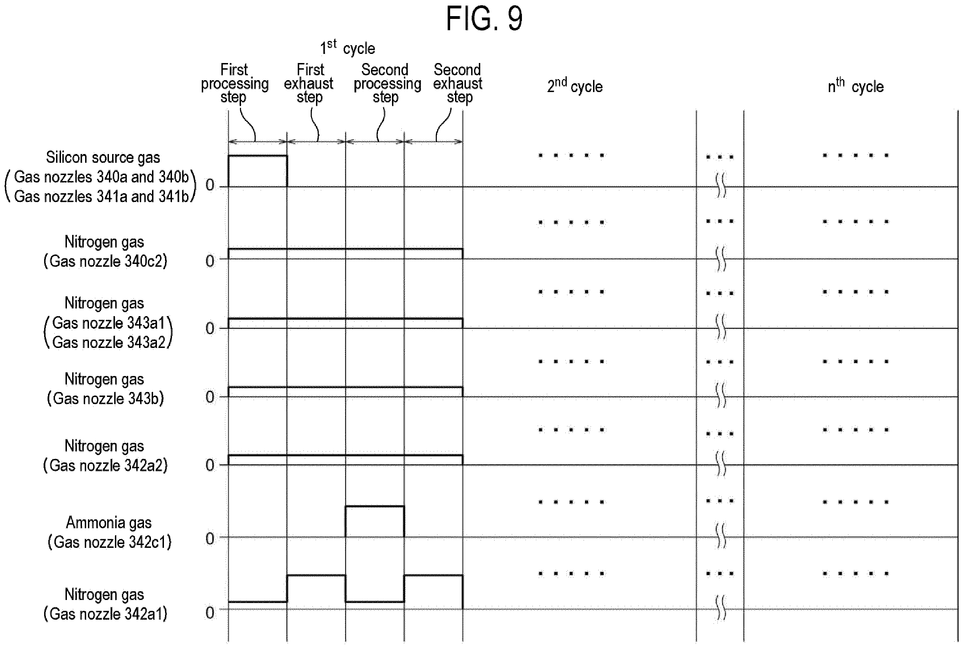

In the film formation step 2, the supply of the first precursor gas and the carrier gas is stopped. By controlling the exhaust pump such as the vacuum pump 246 and the APC valve 244, the inside of the reaction tube 203 is vacuum-exhausted to reach a predetermined pressure (i.e., degree of vacuum). As shown in FIG. 9, the assist gas is continuously supplied from the second gas nozzle 342c2 and the fifth gas nozzle 342a2, and the inert gas is continuously supplied from the third gas nozzles 343a1 and 343a2 and the fourth gas nozzle 343b.

Further, the purge effect is enhanced by increasing a flow rate of the $N_2$ gas supplied from the seventh gas nozzle 342a1. In the film formation step 2, if the inert gas such as an $N_2$ gas used as the carrier gas is supplied into the inner tube 12 as a purge gas, the effect of exhausting the remaining precursor gas can be further enhanced. At the end of film formation step 2, the flow rate of the $N_2$ gas supplied from the seventh gas nozzle 342a1 is reduced to an original flow rate.

(Film Formation Step 3)

In the film formation step 3, a reaction gas as a second precursor gas is supplied into the inner tube 12. As the reaction gas, which is a reactant, a reducing gas as a reducing agent such as, for example, a Si-free gas, an oxidizing gas, hydrogen ($H_2$), or the like may be adopted. Alternatively, for example, an $N_2$-containing gas may be used as the reaction gas.

In the present embodiment, as the second precursor gas supplied from the gas supply pipe 310c, there may be, for example, an ammonia ($NH_3$) gas. While supplying the $NH_3$ gas and the carrier gas into the inner tube 12, the gases are exhausted through the exhaust slits. By supplying the $NH_3$ gas, the $NH_3$ gas reacts with the Si-containing film on the base film of the wafer 200. A SiN film is formed on the wafer 200 by the reaction. The second precursor gas corresponds to a second precursor of the present disclosure. In the present disclosure, the second precursor is not limited to a gas, and may be a liquid substance such as a mist substance or the like.

In the film formation step 3, the assist gas is continuously supplied from the second gas nozzle 342c2, the seventh gas nozzle 342a1, and the fifth gas nozzle 342a2, and the inert gas is continuously supplied from the third gas nozzles 343a1 and 343a2 and the fourth gas nozzle 343b. That is, in the present embodiment, the seventh gas nozzle 342a1 supplies the assist gas when the second precursor gas is supplied from the sixth gas nozzle 342c1.

(Film Formation Step 4)

In the film formation step 4, by controlling the exhaust pump such as the vacuum pump 246 and the APC valve 244 after the film is formed, the inside of the reaction tube 203 is vacuum-exhausted to reach a predetermined pressure (degree of vacuum). The assist gas is continuously supplied from the second gas nozzle 342c2 and the fifth gas nozzle 342a2, and the inert gas is continuously supplied from the third gas nozzles 343a1 and 343a2 and the fourth gas nozzle 343b.

Further, the purge effect is enhanced by increasing the flow rate of the $N_2$ gas from the seventh gas nozzle 342a1. In the film formation step 4, if an inert gas such as an $N_2$ gas used as a carrier gas is supplied into the inner tube 12 as a purge gas, the effect of exhausting the remaining $N_2$-containing reaction gas from the inner tube 12 is further enhanced. At the end of film formation step 4, the flow rate of the $N_2$ gas supplied from the seventh gas nozzle 342a1 is reduced to the original flow rate.

In the present embodiment, in the film formation steps 1 to 4, the seventh gas nozzle 342a1 supplies an assist gas when the first precursor gas is supplied from the first gas nozzles 340a, 340b, 341a and 341b, or when the second precursor gas is supplied from the sixth gas nozzle 342c1. In the present disclosure, the seventh gas nozzle 342a1 may also supply an assist gas except when the first precursor gas is supplied from the first gas nozzles 340a, 340b, 341a and 341b, or except when the second precursor gas is supplied from the sixth gas nozzle 342c1.

Then, by setting the above-described film formation steps 1 to 4 to one cycle and performing the cycle of the film formation steps 1 to 4 a predetermined number of times at step S7 in FIG. 8, a SiN film having a predetermined film thickness can be formed on the wafer 200. In the present embodiment, the film formation steps 1 to 4 are repeated multiple times. In the present disclosure, the film formation steps 1 to 4 may be performed once without being repeated.

After the film formation process described above is completed, the pressure inside the inner tube 12 is returned to a normal pressure (i.e., an atmospheric pressure) at step S8 in FIG. 8. Specifically, for example, an inert gas such as an $N_2$ gas or the like is supplied into the inner tube 12 and exhausted from the inner tube 12. As a result, the inside of the inner tube 12 is purged by the inert gas, and the gas remaining inside the inner tube 12 is removed from the inside of the inner tube 12. Thereafter, the atmosphere inside the inner tube 12 is replaced with the inert gas, and the pressure inside the inner tube 12 is returned to the normal pressure.

Then, by unloading the wafers 200 from the inner tube 12 at step S9 in FIG. 8, the substrate processing according to the present embodiment is completed. The series of steps described above constitute a method of manufacturing a semiconductor device according to the present embodiment.

(Analysis Example)

Next, a result of measuring the in-plane uniformity of the product wafers, which are obtained by the substrate processing method performed using the substrate processing apparatus 10 according to the present embodiment, will be described as an analysis example together with a measurement result in a comparative example. The substrate processing apparatus according to the comparative example differs from the substrate processing apparatus 10 according to the present embodiment in that the fourth gas nozzle 343b is not installed. The configuration of the substrate processing apparatus according to the comparative example is the same as that of the substrate processing apparatus of the present embodiment except for the fourth gas nozzle 343b.

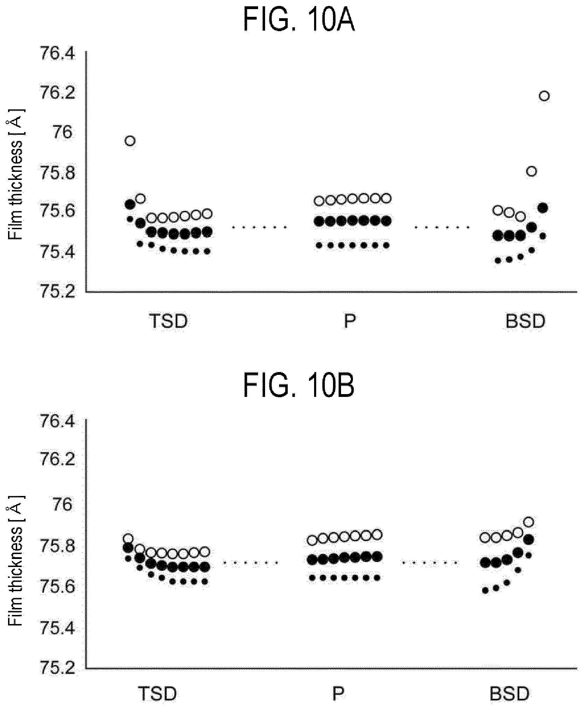

In FIGS. 10A and 10B, the maximum values among the film thicknesses at the 15 points obtained by measurement are represented by white circle data points on an upper side. Further, the minimum values are represented by relatively small black circle data points on a lower side in FIGS. 10A and 10B. That is, in FIGS. 10A and 10B, the film thickness differences between the maximum values and minimum values of the film thicknesses of the product wafers corresponding to the respective positions on the horizontal axis are exemplified by lengths between the white circle data points on the upper side and the relatively small black circle data points on the lower side. In addition, the average values of the film thicknesses at the 15 points are represented by relatively large black circle data points between the maximum values and the minimum values in FIGS. 10A and 10B.

As shown in FIG. 10A, in the case of the comparative example, the thickness difference of each of the uppermost product wafer in the upper dummy region TSD, the lowermost product wafer in the lower dummy region BSD, and the second product wafer from the bottom is relatively large. On the other hand, as shown in FIG. 10B, in the present embodiment, the thickness difference of each of the uppermost product wafer in the upper dummy region TSD, the lowermost product wafer in the lower dummy region BSD, and the second product wafer from the bottom is reduced as compared with the comparative example.

The in-plane uniformity of the lowermost product wafer in the lower dummy region BSD was 1.0% in the comparative example, but 0.2% in the present embodiment, so that it is possible to reduce the in-plane uniformity by 0.8 points as compared with the comparative example. In addition, the in-plane uniformity of the uppermost product wafer in the upper dummy region TSD was 0.5% in the comparative example, but 0.1% in the present embodiment, so that it is possible to reduce the in-plane uniformity by 0.4 points as compared with the comparative example. That is, in the present embodiment, the in-plane uniformity of the plurality of product wafers 200 positioned at the end portion on the side dummy region side among the plurality of wafers 200 accommodated in the product region P was 0.2% or less.

Further, in the analysis example, the inter-plane uniformity of all the product wafers in the present embodiment was equivalent to that in the comparative example. That is, according to the present embodiment, it is possible to adjust the in-plane uniformity of the end product wafers while securing the inter-plane uniformity of all the product wafers.

(Operation Effect)

According to the present embodiment, one or more of the following effects may be obtained.

In the substrate processing apparatus 10 according to the present embodiment, the inert gas is directly supplied toward the end product wafers by the fourth gas nozzle 343b, which supplies the inert gas only to the side dummy regions. Therefore, even if the film thickness of the end product wafers increases, it is possible to effectively reduce the film thickness. Accordingly, it is possible to locally improve the in-plane uniformity of the end product wafers among the plurality of product wafers arranged in the product region P.

In particular, in the present embodiment, the fourth gas nozzle 343b installed on the downstream side of the gas flow on the substrate is combined with the second gas nozzle 342c2 and the fifth gas nozzle 34a2 installed on the upstream side. Therefore, it is possible to independently control the in-plane uniformity of the upper product wafers, the in-plane uniformity of the lower product wafers, and the inter-plane uniformity of all the product wafers.

In addition, in the present embodiment, the fourth gas nozzle 343b is arranged on the downstream side. Therefore, it is possible to reduce the influence on all the wafers. That is, since the inert gas is injected from the fourth gas nozzle 343b only to the end product wafers, it is possible to reduce the influence on the gas injected from the other nozzles for adjusting the inter-surface uniformity over all the product wafers. The effects of the method of manufacturing a semiconductor device and the substrate processing program using the substrate processing apparatus 10 according to the present embodiment are the same as those of the substrate processing apparatus 10.

In the present embodiment, the second gas nozzle 342c2 and the third gas nozzles 343a1 and 343a2 are installed on both sides, and the fourth gas nozzle 343b is arranged on the downstream side of the center of the substrate in the flow of the first precursor. The in-plane uniformity of all the product wafers is controlled by both the second gas nozzle 342c2 arranged on the upstream side and the third gas nozzles 343a1 and 343a2 arranged on the downstream side. Therefore, the reliability of control of the in-plane uniformity of the end product wafers can be improved by the fourth gas nozzle 343b.

Further, in the present embodiment, the substrate processing apparatus further includes the fifth gas nozzle 34a2 arranged on the upstream side of the center of the substrate, and including injection holes for supplying the assist gas only to the substrates arranged in the lower dummy region BSD. Further, the second gas nozzle 342c2 includes injection holes for supplying the assist gas only to the substrates in the upper dummy region TSD. Therefore, it is possible to independently control the in-plane uniformity of the upper product wafers and the in-plane uniformity of the lower product wafers.

In addition, in the present embodiment, the substrate processing apparatus further include the sixth gas nozzle 342c1 configured to supply the second precursor gas, and the seventh gas nozzle 342a1 configured to supply the assist gas from the upstream side. Since the first precursor gas and the second precursor gas can be diluted by the seventh gas nozzle 342a1, it is possible to improve a supply efficiency of each precursor gas. In addition, the seventh gas nozzle 342a1 can improve a gas replacement performance during the film formation process, and can prevent the gas coming out of the supply buffer 222 from being returned to the supply buffer 222 again due to the vortices, turbulence, and the like generated in the process chamber 201, that is, generation of a return flow.

In addition, in the present embodiment, a pair of third gas nozzles 343a1 and 343a2 is installed on both sides of the straight line connecting the main exhaust part and the center of the substrate. Therefore, since the inert gas can be efficiently supplied into the process chamber 201, the generation of vortices in the process chamber can be suppressed, and an amount of the nitrogen gas used can be reduced as a whole.

In addition, in the present embodiment, the seventh gas nozzle 342a1 supplies the assist gas when the first precursor gas is supplied from the first gas nozzles 340a, 340b, 341a and 341b, or when the second precursor gas is supplied from the sixth gas nozzle 342c1. Therefore, it is possible to further improve the supply efficiency of the precursor gas, improve the gas replacement capability, and suppress the return flow.

Moreover, in the present embodiment, the sixth gas nozzle 342c1 and the seventh gas nozzle 342a1 are arranged such that the first gas nozzles 340a, 340b, 341a and 341b are interposed therebetween. Further, the seventh gas nozzle 342a1 supplies the assist gas while the first precursor gas, which is the precursor gas containing a Group 14 element, is being supplied from the first gas nozzles 340a, 340b, 341a and 341b. Therefore, it is possible to further improve the supply efficiency of the precursor gas, improve the gas replacement capability, and suppress the return flow.

Further, in the present embodiment, the fourth gas nozzle 343b is arranged outside the imaginary vertical plane A on the downstream side of the flow of the first precursor gas. Further, the fourth gas nozzle 343b injects the inert gas toward the upstream region located outside the center C1 of the wafer 200 and positioned between the peripheral edge of the wafer 200 on the side where the fourth gas nozzle 343b is arranged and the center C1 of the wafer 200. Therefore, it is possible to maximize the wafer film thickness reduction effect by the fourth gas nozzle 343b.

In addition, in the present embodiment, the partition plates protruding from the side surfaces of the first gas nozzles 340a, 340b, 341a and 341b to prevent the gas from flowing in the vertical direction are installed on the side surfaces of the first gas nozzles 340a, 340b, 341a and 341b below the lower dummy region BSD in the process chamber 201. As a result, the flow rate of the exhausted precursor gas is made more uniform, and the inter-plane uniformity of the films between the surfaces of the plurality of wafers 200 is improved.

Moreover, in the present embodiment, the fourth gas nozzle 343b is installed adjacent to one of the pair of third gas nozzles 343a1 and 343a2. In addition, the process chamber 201 has the sub-exhaust slits 238 between the third gas nozzles 343a1 and 343a2 and the fourth gas nozzle 343b. As a result, the flow rate of the exhausted precursor gas is made more uniform, and the inter-plane uniformity of the films between the surfaces of the plurality of wafers 200 is improved.

Further, in the present embodiment, the opening width of one main exhaust slit 236 along the circumferential direction of the cylindrical portion becomes narrower along a direction from the opposite side of the main exhaust port 230 to the main exhaust port 230 along the axial direction of the cylindrical portion (i.e., from the top to the bottom). In addition, the opening width of each of the two sub-exhaust slits 238 along the circumferential direction of the cylindrical portion becomes narrower along a direction from the opposite side of each of the pair of sub-exhaust ports to the pair of sub-exhaust ports along the axial direction of the cylindrical portion. Therefore, the flow rate of the exhausted precursor is made more uniform between the wafers 200 stacked in multiple stages along the axial direction, thereby improving the inter-plane uniformity of the films between the surfaces of the plurality of wafers 200.

Further, in the present embodiment, a member such as a fin or the like as an exhaust flow rate adjuster, which protrudes outward from the side wall and having a protrusion length that becomes shorter along a direction from the opposite side of the exhaust port to the exhaust port in the vertical direction, may be installed in a portion of the side wall of the process chamber 201 forming a main exhaust portion. The difference between the flow rate of the precursor gas discharged from the bottom side near the main exhaust port and the sub-exhaust port and the flow rate of the precursor gas discharged from the top side is made small by the exhaust flow rate adjuster. Therefore, the flow rate of the exhausted precursor gas is made uniform between the wafers 200 stacked in multiple stages along the vertical direction. As a result, the inter-plane uniformity of the films between the surfaces of the plurality of wafers 200 is improved. Moreover, it is not necessary to process the side wall of the cylindrical portion such that the opening width of the slit becomes narrower along a direction from the opposite side of the exhaust port toward the exhaust port along the axial direction.

Further, in the present embodiment, the in-plane uniformity of all the product wafers is controlled by both the second gas nozzle 342c2 arranged on the upstream side and the third gas nozzles 343a1 and 343a2 arranged on the downstream side. Moreover, the fourth gas nozzle 343b is arranged at a position closer to the main exhaust port than the third gas nozzles 343a1 and 343a2. Accordingly, it is possible to further improve the reliability of control of the in-plane uniformity of the end product wafers by the fourth gas nozzle 343b.

Further, in the present embodiment, the fourth gas nozzle 343b includes the upper injection hole opened toward at least one substrate excluding the uppermost substrate among the plurality of substrates accommodated in the upper dummy region TSD. In addition, the fourth gas nozzle 343b includes the lower injection hole opened toward at least two substrates excluding the lowest stage among the plurality of substrates accommodated in the lower dummy region BSD. Therefore, the excessive dilution of the precursor gas in the upper dummy region TSD and the lower dummy region BSD is suppressed. Moreover, the diffusion of active species across the side dummy regions and the product region P can be reduced. Accordingly, it is possible to further improve and stabilize the inter-plane uniformity.

Further, in the present embodiment, the third gas nozzles 343a1 and 343a2 include a plurality of horizontal injection holes opened substantially parallel to the surface of the substrate, and an inclined injection hole installed at a position higher than the uppermost horizontal injection hole among the plurality of horizontal injection holes and opened obliquely upward. Accordingly, it is possible to further reduce the diffusion of active species across the upper dummy region TSD and the product region P.

Further, in the present embodiment, each of the first gas nozzles 340a, 340b, 341a and 341b includes three or more injection holes arranged along a direction substantially parallel to the surface of the substrate. Therefore, the inert gas can be efficiently supplied into the process chamber 201, which makes it possible to suppress the generation of vortices in the process chamber 201.

Further, in the present embodiment, the first gas nozzles 340a, 340b, 341a and 341b are a nozzle array in which a plurality of linear circular pipes are arranged along the circumferential direction of the process chamber 201. For this reason, the processing gas can be efficiently supplied at a wide angle in a planar manner, which makes it possible to suppress the generation of vortices in the process chamber 201.

Further, in the present embodiment, the in-plane uniformity of at least one selected from the group of the product wafers on the top side and the product wafers on the bottom side is 0.2% or less. As a result, all the product wafers satisfy the required in-plane uniformity, which makes it possible to achieve a high yield.

<Other Embodiments of the Present Disclosure>

While the present disclosure has been described through the embodiment disclosed above, the discussion and drawings forming part of the present disclosure should not be understood as limiting the present disclosure. The present disclosure is not limited to the embodiment described above, and various modifications may be made without departing from the scope of the present disclosure.

(First Modification)

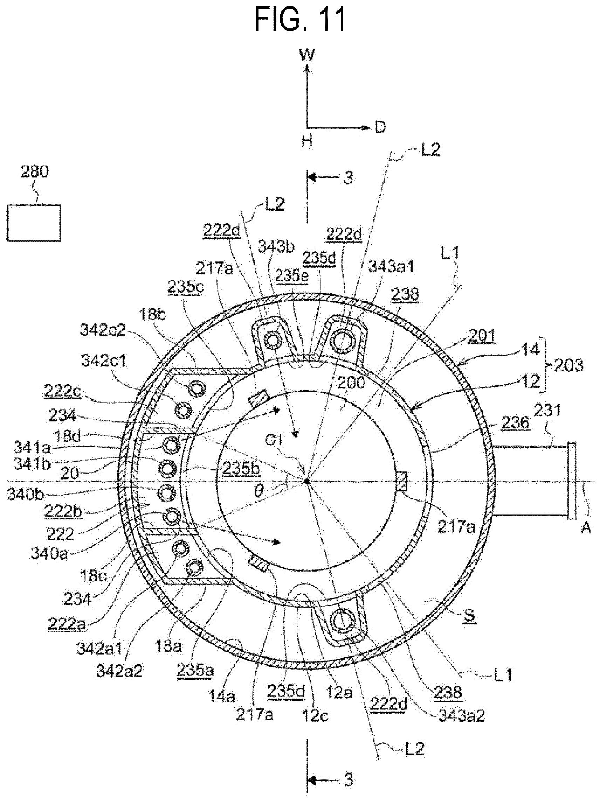

For example, in the present embodiment, the arrangement position of the fourth gas nozzle 343b is exemplified on the downstream side. However, as shown in FIG. 11, the arrangement position of the fourth gas nozzle 343b is not limited to the downstream side and may be on the upstream side. Other configurations of the substrate processing apparatus according to the first modification are the same as those of the above-described embodiment, and the redundant description thereof will be omitted.

As in the first modification, even with the fourth gas nozzle 343b arranged on the upstream side, as in the above-described embodiment, it is possible to locally improve the in-plane uniformity of the end product wafers among the plurality of product wafers arranged in the product region P. Further, other effects of the substrate processing apparatus according to the first modification are the same as those of the above-described embodiment.

(Second Modification)

Further, in the present disclosure, the substrate processing apparatus may be applied to other processes, for example, an oxidation process. For example, when the oxidation process is performed in the second modification, the first gas nozzles 340a, 340b, 341a and 341b and the sixth gas nozzle 342c1 may be arranged such that the seventh gas nozzle 342a1 is interposed therebetween on both sides. In addition, a type of gas injected from each nozzle may be different from that in the above-described embodiment.

Specifically, for example, the nozzle 342a1 in FIG. 11 is the seventh gas nozzle 342a1 in the above-described embodiment, but functions as the first gas nozzles 340a, 340b, 341a and 341b in the second modification. Further, the nozzles 340a, 340b, 341a and 341b in FIG. 11 are the first gas nozzles 340a, 340b, 341a and 341b in the above-described embodiment, but function as the seventh gas nozzle 342a1 in the second modification.

The nozzle 342a1 as the first gas nozzles 340a, 340b, 341a and 341b supplies one of the oxidizing gas and the reducing gas. The nozzle 342c1 as the sixth gas nozzle 342c1 supplies the other of the oxidizing gas and the reducing gas.

For example, an oxygen (O)- and hydrogen (H)-containing gas may be used as the oxidizing gas, which is an oxidizing agent. As the O- and H-containing gas, for example, a water vapor ($H_2O$ gas), a hydrogen peroxide ($H_2O_2$) gas, a hydrogen ($H_2$) gas + oxygen ($O_2$) gas, an $H_2$ gas + ozone ($O_3$) gas, and the like may be used. As the oxidizing agent, in addition to the O- and H-containing gas, for example, an oxygen (O)-containing gas may be used. As the O-containing gas, for example, an $O_2$ gas, an $O_3$ gas, a nitrous oxide ($N_2O$) gas, a nitric oxide (NO) gas, a nitrogen dioxide ($NO_2$) gas, a carbon monoxide (CO) gas, a carbon dioxide ($CO_2$) gas, and the like may be used. The O- and H-containing gas is also a kind of O-containing gas. One or more of these gases may be used as the oxidizing agent.

In this specification, the parallel notation of two gases such as "$H_2$ gas + $O_2$ gas" means a mixed gas of a $H_2$ gas and an $O_2$ gas. When supplying a mixed gas, two gases may be mixed (i.e., premixed) in the supply pipe and then supplied into the process chamber 201. Alternatively, two gases may be separately supplied from different supply pipes into the process chamber 201 and mixed (post-mixed) in the process chamber 201.

For example, the nozzle 342a1 as the first gas nozzles 340a, 340b, 341a and 341b in the second modification supplies an $O_2$ gas as an oxidizing gas. Further, the nozzle 342c1 as the sixth gas nozzle 342c1 supplies a $H_2$ gas as a reducing gas. Further, the nozzles 340a, 340b, 341a and 341b serving as the seventh gas nozzle 342a1 in the second modification supply an $N_2$ gas as an assist gas. In the second modification, all gases are supplied to the wafers simultaneously and continuously during the oxidation process.

Therefore, in the second modification, it is possible to generate oxygen active species or hydroxyl radicals inside the process chamber 201. In addition, in the second modification, the seventh gas nozzle 342a1 may be configured to supply an inert gas when at least one selected from the group of the first gas nozzles 340a, 340b, 341a and 341b and the sixth gas nozzle 342c1 supplies a gas in the oxidation process. Other configurations of the substrate processing apparatus according to the second modification are the same as those of the above-described embodiment, and the duplicate description thereof will be omitted.

In addition, in the above-described embodiments, there has been described the example in which a film is formed using a batch-type substrate processing apparatus that processes a plurality of substrates at a time. The present disclosure is not limited to the embodiments described above, and may be suitably applied, for example, to a case of forming a film using a single-substrate-type substrate processing apparatus that processes one or several substrates at a time. Further, in the above-described embodiments, there has been described the example in which a film is formed using a substrate processing apparatus having a hot wall type process furnace. The present disclosure is not limited to the embodiments described above, and may be suitably applied to a case of forming a film using a substrate processing apparatus having a cold wall type process furnace.

Even when these substrate processing apparatuses are used, each process can be performed under the same processing procedures and processing conditions as those of the above-described embodiments and modifications, and effects similar to those of the above-described embodiments and modifications can be obtained.

Further, for example, in the above-described embodiments of the present disclosure, various processors other than the CPU may execute the substrate processing executed by the CPU 121a reading the software (program). The processor in this case may be a dedicated electric circuit or the like, which is a processor having a circuit configuration specially designed to perform a specific process, such as a PLD (Programmable Logic Device) whose circuit configuration can be changed after manufacturing, for example, a FPGA (Field-Programmable Gate Array), and an ASIC (Application Specific Integrated Circuit).

Further, the substrate processing may be performed by one of these various processors, or by a combination of two or more processors of the same or different type (e.g., a plurality of FPGAs, a combination of CPU and FPGA, etc.). In addition, the hardware structure of these various processors is, more specifically, an electric circuit in which circuit elements such as semiconductor elements are combined.

Further, in each of the above-described embodiments, there has been described the example in which the substrate processing program is stored (installed) in advance in the memory 121c such as a ROM or a storage. However, the present disclosure is not limited thereto. The program may be provided by being recorded in a computer-readable recording medium such as a CD-ROM (Compact Disk-Read Only Memory), a DVD-ROM (Digital Versatile Disk-Read Only Memory), and a USB (Universal Serial Bus) memory. In addition, the program may be downloaded from an external device via a network.

In addition, the present disclosure may be configured by partially combining the configurations included in the above-described embodiments, modifications, and forms. In the present disclosure configured by combinations, the processing procedures and processing conditions to be executed can be set, for example, in the same manner as the processing procedures and processing conditions described in the aspect according to the present embodiment. The present disclosure includes various embodiments not described above, and the technical scope of the present disclosure is defined only by the subject matters defined in the claims.

According to the present disclosure in some embodiments, it is possible to locally improve the in-plane uniformity of an end product wafer among a plurality of product wafers.

While certain embodiments have been described, these embodiments have been presented by way of example only, and are not intended to limit the scope of the disclosures. Indeed, the embodiments described herein may be embodied in a variety of other forms. Furthermore, various omissions, substitutions, and changes in the form of the embodiments described herein may be made without departing from the disclosures. The accompanying claims and their equivalents are intended to cover such forms or modifications as would fall within the scope of the disclosures.

**Claims**

1. A substrate processing apparatus (10) comprising:

   (a) a process chamber (201) configured to accommodate a plurality of substrates (200) arranged vertically, provided with a product region (P) and a dummy region (TSD, BSD), which is provided on at least one selected from the group of an upper side of the product region (P) and a lower side of the product region (P), in the process chamber (201), and including a main exhauster (236) on a lateral side of the process chamber (201);
   (b) a first injector (340a, 340b, 341a, 341b) extending vertically within the process chamber (201) on an opposite side from the main exhauster (236), and configured to supply a first precursor toward the substrates (200) accommodated in the product region (P) and the dummy region (TSD, BSD);
   (c) at least one selected from the group of a second injector (342c2) and a third injector (343a1, 343a2), wherein the second injector (342c2) is installed on an upstream side of a center of the plurality of substrates (200) accommodated inside the process chamber (201) in a flow of the first precursor and configured to supply an assist gas for diluting the first precursor toward substrates (200) accommodated in the dummy region (TSD, BSD) at a larger amount than substrates (200) accommodated in the product region (P), and the third injector (343a1, 343a2) is installed on a downstream side of the center of the substrates (200) in the flow of the first precursor and configured to supply an inert gas toward the substrates (200) accommodated in the product region (P) and the substrates (200) accommodated in the dummy region (TSD, BSD); and
   (d) a fourth injector (343b) configured to supply an inert gas only to the dummy region (TSD, BSD).

2. The substrate processing apparatus (10) of Claim 1, wherein both the second injector (342c2) and the third injector (343a1, 343a2) are installed, and
   wherein the fourth injector (343b) is arranged on the downstream side of the center of the accommodated substrates (200) in the flow of the first precursor.

3. The substrate processing apparatus (10) of Claim 1, further comprising:

   a fifth injector (342a2) arranged on the upstream side of the center of the accommodated substrates (200) in the flow of the first precursor and including an injection hole configured to supply an assist gas toward the substrates (200) accommodated in a lower dummy region (BSD) which is the dummy region (BSD) arranged on the lower side,
   wherein the second injector (342c2) has an injection hole for supplying an assist gas only to the substrates (200) accommodated in an upper dummy region (TSD) which is the dummy region (TSD) arranged on the upper side.

4. The substrate processing apparatus (10) of Claim 1, further comprising:

a sixth injector (342c1) extending in a vertical direction, arranged inside the process chamber (201) to face the main exhauster (236), and configured to supply a second precursor toward at least the substrates (200) accommodated in the product region (P); and

a seventh injector (342a1) extending in the vertical direction, arranged on the upstream side of the center of the accommodated substrates (200) in the flow of the first precursor, and configured to supply an assist gas, which is different from the first precursor and the second precursor, toward at least the substrates (200) accommodated in the product region (P).

5. The substrate processing apparatus (10) of Claim 1, wherein the third injector (343a1, 343a2) is installed as a pair of third injectors (343a1, 343a2) on both sides of an imaginary vertical plane connecting the main exhauster (236) and the center of the accommodated substrates (200).

6. The substrate processing apparatus (10) of Claim 4, wherein the seventh injector (342a1) supplies the assist gas when the first precursor is supplied from the first injector (340a, 340b, 341a, 341b) or when the second precursor is supplied from the sixth injector (342c1).

7. The substrate processing apparatus (10) of Claim 4, wherein the sixth injector (342c1) and the seventh injector (342a1) are arranged such that the first injector (340a, 340b, 341a, 341b) is interposed between the sixth injector (342c1) and the seventh injector (342a1), and

wherein the seventh injector (342a1) supplies the assist gas when the first precursor, which is a precursor gas containing a Group 14 element, is supplied from the first injector (340a, 340b, 341a, 341b).

8. The substrate processing apparatus (10) of Claim 1, wherein the fourth injector (343b) is arranged on the downstream side in the flow of the first precursor and outside an imaginary vertical plane connecting the main exhauster (236) and the center of the accommodated substrates (200) and is configured to inject an inert gas toward an upstream region, which is located outside the center of the accommodated substrates (200) and between a peripheral edge of the accommodated substrates (200) on a side where the fourth injector (343b) is arranged and the center of the accommodated substrates (200).

9. The substrate processing apparatus (10) of Claim 1, wherein a partition plate for blocking a flow of gas in a vertical direction is installed below a lower dummy region (BSD) which is the dummy region (BSD) arranged on the lower side.

10. The substrate processing apparatus (10) of Claim 5, wherein the fourth injector (343b) is installed adjacent to one of the third injectors (343a1, 343a2), and

wherein the process chamber (201) includes sub-exhausters between the third injector (343a1, 343a2)s and the fourth injector (343b).

11. The substrate processing apparatus (10) of Claim 1, wherein an opening width of the main exhauster (236) along a circumferential direction of the process chamber (201) becomes narrower along a direction from the upper side to the lower side, or

wherein an exhaust flow rate adjuster, which protrudes outward from a side wall of the process chamber (201) and has a protrusion length decreasing along a direction from the upper side to the lower side, is installed in a portion of the side wall of the process chamber (201), which forms the main exhauster (236).

12. The substrate processing apparatus (10) of Claim 1, wherein the fourth injector (343b) includes an upper injection hole opened toward at least one substrate excluding an uppermost substrate among the plurality of substrates (200) accommodated in an upper dummy region (TSD, BSD), which is the dummy region (TSD, BSD) on the upper side, and a lower injection hole opened toward at least two substrates (200) excluding a lowermost stage among the plurality of substrates (200) accommodated in a lower dummy region (TSD, BSD), which is the dummy region (TSD, BSD) on the lower side.

13. The substrate processing apparatus (10) of Claim 1, wherein the at least one selected from the group of the second injector (342c2) and the third injector (343a1, 343a2) includes the third injector (343a1, 343a2), and

wherein the third injector (343a1, 343a2) includes a plurality of horizontal injection holes opened substantially parallel to surfaces of the accommodated substrates (200) and an inclined injection hole provided at a position higher than an uppermost horizontal injection hole among the plurality of horizontal injection holes and opened obliquely upward.

14. A method of manufacturing a semiconductor device, comprising:

(a) accommodating a plurality of substrates (200) in a process chamber (201) in a state arranged along a vertical direction, wherein the process chamber (201) is provided with a product region (P) and a dummy region (TSD, BSD), which is provided on at least one selected from the group of an upper side of the product region (P) and a lower side of the product region (P), in the process chamber (201) and has a main exhauster (236) on a lateral side of the process chamber (201);

(b) supplying a first precursor toward the substrates (200) accommodated in the product region (P) and the dummy region (TSD, BSD) by using a first injector (340a, 340b, 341a, 341b) extending in a vertical direction and arranged inside the process chamber (201) to face the main exhauster (236);

(c) performing at least one of supplying an assist gas for diluting the first precursor toward the substrates (200) accommodated in the dummy region (TSD, BSD) at a larger amount than the substrates (200) accommodated in the product region (P) by using a second injector (342c2), which is installed on an upstream side of a center of the substrates (200) accommodated inside the process chamber (201) in a flow of the first precursor, and supplying an inert gas toward the substrates (200) accommodated in the product region (P) and the substrates (200) accommodated in the dummy region (TSD, BSD) by using a third injector (343a1, 343a2), which is installed on a downstream side of the center of the substrates (200) in the flow of the first precursor; and

(d) supplying an inert gas only to the dummy region (TSD, BSD).

**15.** Use of the substrate processing apparatus (10) of Claim 1 for substrate processing.

FIG. 1

# FIG. 2

# FIG. 3

# FIG. 4

# FIG. 5

## FIG. 6

# FIG. 7

10

280

320a,320b,320c,320d,320f,320g,320h,320i

MFC

330a,330b,330c,330d,330f,330g,330h,330i

121a
CPU

Valve

121b
RAM

122
Input/output device

Pressure sensor ~ 245

121c
Memory

123
External memory

APC valve ~ 244

121d
I/O port

Vacuum pump ~ 246

121e

Heater ~ 207

Rotator ~ 267

Elevator ~ 115

EP 4 365 328 A1

# FIG. 8

```
                    ┌──────────┐
                    │  Start   │
                    └──────────┘
                         │
                         ▼
         ┌──────────────────────────┐
         │    Loading substrates    │──S1
         └──────────────────────────┘
                         │
                         ▼
         ┌──────────────────────────┐
         │   Pressure regulation/   │──S2
         │  temperature adjustment  │
         └──────────────────────────┘
                         │
                         ▼
         ┌──────────────────────────┐
         │    Precursor gas supply  │──S3
         └──────────────────────────┘
                         │
                         ▼
         ┌──────────────────────────┐
  Film   │   Precursor gas exhaust  │──S4
formation└──────────────────────────┘
 process                 │
                         ▼
         ┌──────────────────────────┐
         │    Reaction gas supply   │──S5
         └──────────────────────────┘
                         │
                         ▼
         ┌──────────────────────────┐
         │   Reaction gas exhaust   │──S6
         └──────────────────────────┘
                         │
                         ▼       S7
                   ╱──────────╲
                  ╱ Performed a ╲      No
                 ╱ predetermined ╲────────
                 ╲ number        ╱
                  ╲ of times?   ╱
                   ╲──────────╱
                         │ Yes
                         ▼
         ┌──────────────────────────┐
         │ Atmospheric pressure     │──S8
         │ restoration              │
         └──────────────────────────┘
                         │
                         ▼
         ┌──────────────────────────┐
         │  Unloading the substrates│──S9
         └──────────────────────────┘
                         │
                         ▼
                    ┌──────────┐
                    │   End    │
                    └──────────┘
```

FIG. 9

## FIG. 10A

## FIG. 10B

# FIG. 11

Europäisches
Patentamt

European
Patent Office

Office européen
des brevets

# EUROPEAN SEARCH REPORT

Application Number

EP 23 20 1872

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/312655 A1 (NISHIDA KEIGO [JP] ET AL) 1 October 2020 (2020-10-01) | 1-13,15 | INV. C23C16/34 |
| Y | * page 1, paragraphs 4,5 - page 2, paragraphs 25,27,28,29 * <br> * page 3, paragraphs 30,31,34,36,38 * <br> * page 4, paragraph 43; figures 2,5-10 * | 14 | C23C16/44 <br> C23C16/455 <br> H01L21/02 |
| Y | US 2020/407851 A1 (HIRAMATSU HIROAKI [JP] ET AL) 31 December 2020 (2020-12-31) <br> * page 1, paragraphs 4,5 - page 5, paragraph 50 * <br> * page 6, paragraphs 54,58,59; figure 8A * | 14 | |
| A | US 2019/096738 A1 (OKAJIMA YUSAKU [JP] ET AL) 28 March 2019 (2019-03-28) <br> * the whole document * | 1-15 | |
| A | US 2021/246554 A1 (SHIMADA HIRONORI [JP] ET AL) 12 August 2021 (2021-08-12) <br> * page 1, paragraph 6 - page 2, paragraph 35 * <br> * page 3, paragraphs 35,37 * | 1-15 | TECHNICAL FIELDS SEARCHED (IPC) <br><br> C23C |
| A | WO 2022/065163 A1 (KOKUSAI ELECTRIC CORP [JP]) 31 March 2022 (2022-03-31) <br> * the whole document * | 1-15 | H01L |

The present search report has been drawn up for all claims

| Place of search | Date of completion of the search | Examiner |
|---|---|---|
| The Hague | 22 March 2024 | Boussard, Nadège |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...................................................................

& : member of the same patent family, corresponding document

EPO FORM 1503 03.82 (P04C01)

EP 4 365 328 A1

## ANNEX TO THE EUROPEAN SEARCH REPORT
## ON EUROPEAN PATENT APPLICATION NO.

EP 23 20 1872

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2024

| Patent document cited in search report | | | Publication date | Patent family member(s) | | Publication date |
|---|---|---|---|---|---|---|
| US 2020312655 | A1 | | 01-10-2020 | CN | 111755355 A | 09-10-2020 |
| | | | | JP | 7113862 B2 | 05-08-2022 |
| | | | | JP | 2020167400 A | 08-10-2020 |
| | | | | KR | 20200115208 A | 07-10-2020 |
| | | | | SG | 10202002578V A | 29-10-2020 |
| | | | | TW | 202102711 A | 16-01-2021 |
| | | | | US | 2020312655 A1 | 01-10-2020 |
| | | | | US | 2023170212 A1 | 01-06-2023 |
| US 2020407851 | A1 | | 31-12-2020 | CN | 110998806 A | 10-04-2020 |
| | | | | JP | 6919060 B2 | 11-08-2021 |
| | | | | JP | WO2019180905 A1 | 11-03-2021 |
| | | | | KR | 20200118181 A | 14-10-2020 |
| | | | | KR | 20230113657 A | 31-07-2023 |
| | | | | SG | 11202008792X A | 29-10-2020 |
| | | | | TW | 201940248 A | 16-10-2019 |
| | | | | US | 2020407851 A1 | 31-12-2020 |
| | | | | US | 2022145464 A1 | 12-05-2022 |
| | | | | WO | 2019180905 A1 | 26-09-2019 |
| US 2019096738 | A1 | | 28-03-2019 | CN | 109559975 A | 02-04-2019 |
| | | | | JP | 6820816 B2 | 27-01-2021 |
| | | | | JP | 2019062053 A | 18-04-2019 |
| | | | | KR | 20190035548 A | 03-04-2019 |
| | | | | TW | 201930641 A | 01-08-2019 |
| | | | | US | 2019096738 A1 | 28-03-2019 |
| US 2021246554 | A1 | | 12-08-2021 | CN | 110534456 A | 03-12-2019 |
| | | | | JP | 6856576 B2 | 07-04-2021 |
| | | | | JP | 7103696 B2 | 20-07-2022 |
| | | | | JP | 2019203182 A | 28-11-2019 |
| | | | | JP | 2021114606 A | 05-08-2021 |
| | | | | KR | 20190134490 A | 04-12-2019 |
| | | | | KR | 20210045978 A | 27-04-2021 |
| | | | | TW | 202004878 A | 16-01-2020 |
| | | | | TW | 202133239 A | 01-09-2021 |
| | | | | US | 2019360098 A1 | 28-11-2019 |
| | | | | US | 2021246554 A1 | 12-08-2021 |
| | | | | US | 2023112057 A1 | 13-04-2023 |
| WO 2022065163 | A1 | | 31-03-2022 | CN | 115989566 A | 18-04-2023 |
| | | | | JP | 7397214 B2 | 12-12-2023 |
| | | | | JP | WO2022065163 A1 | 31-03-2022 |
| | | | | KR | 20230053680 A | 21-04-2023 |
| | | | | US | 2023227979 A1 | 20-07-2023 |
| | | | | WO | 2022065163 A1 | 31-03-2022 |

For more details about this annex : see Official Journal of the European Patent Office, No. 12/82

EPO FORM P0459

page 1 of 2

34

**ANNEX TO THE EUROPEAN SEARCH REPORT
ON EUROPEAN PATENT APPLICATION NO.**

EP 23 20 1872

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2024

| Patent document cited in search report | Publication date | Patent family member(s) | Publication date |
|---|---|---|---|
| ------------------------------------------------------------------------------------- | | | |

EPO FORM P0459

**EP 4 365 328 A1**

## REFERENCES CITED IN THE DESCRIPTION

**Patent documents cited in the description**

* JP 2022175067 A